# EUROPEAN PATENT SPECIFICATION

(11) **EP 2 791 946 B1**
(45) Date of publication and mention of the grant of the patent: **14.09.2016**
(21) Application number: 12808632.9
(22) Date of filing: 13.12.2012
(51) Int. Cl.: H01B 1/22, B23K 35/36

(54) **COMPOSITION AND CONDUCTOR FORMED THEREFROM**
ZUSAMMENSETZUNG UND DARAUS HERGESTELLTER LEITER
COMPOSITION ET CONDUCTEUR FORMÉ À PARTIR DE CELLE-CI

(30) Priority: 13.12.2011 US 201161569959 P
(43) Date of publication of application: 22.10.2014
(73) Proprietor: Dow Corning Corporation, Midland, Michigan 48686-0994 (US)
(72) Inventor: BOULORD, Caroline, B-1180 Uccle (BE); CHEVALIER, Pierre, Maurice, F-59000 Lille (FR); POWELL, Nicholas, E., Midland, MI 48640 (US); ZAMBOVA, Adriana, Petkova, Midland, MI 48640 (US)
(74) Representative: Fyfe, Fiona Allison Watson
(86) International application number: PCT/US2012/069503
(87) International publication number: WO 2013/090570

(56) References cited:
- EP-A1- 0 933 010
- US-A1- 2003 051 770

## Description

### CROSS REFERENCE TO RELATED APPLICATIONS

This application claims the benefit of U.S. Provisional Patent Application Serial No. 61/569,959, filed on December 13th, 2011, which is incorporated herewith by reference in its entirety.

### FIELD OF THE INVENTION

The present invention generally relates to a composition, and more specifically to a composition and to a conductor formed from the composition.

### BACKGROUND

Front and rear surface metallization is an important aspect of photovoltaic (PV) cells which allows for collection and transport of charge carriers. In front PV cell constructs, the metallization is generally in the form of a grid, which includes narrow lines or "fingers" of conductive material which connect to wider busbars. Tabbing, e.g. ribbon, is soldered to the busbars to connect multiple PV cells together (e.g. in series). Typically, the grid is formed using pastes which include silver (Ag) as a primary component due to its excellent conductivity. In rear PV cell constructs, the metallization is generally in the form of an electrode (e.g. a layer of aluminum), which typically includes contacts formed from Ag. The contacts are disposed through the rear layer. The contacts can be in the form of busbars or pads.

Metallization relying on Ag is often used in other applications as well, such as in circuit boards or other applications requiring conductive material for current transport and/or electrical connection. Unfortunately, such metallization makes up a substantial portion of overall manufacturing cost due to reliance on Ag. As such, there remains an opportunity to provide improved compositions and conductors formed therefrom which are suitable for current transport and/or electrical connection in a variety of applications.

### SUMMARY OF THE INVENTION

The present invention provides a composition comprising a metal powder. The composition further comprises a solder powder which has a lower melting temperature than a melting temperature of the metal powder. The composition further comprises a polymer and a carboxylated-polymer different from the polymer. The carboxylated-polymer is useful for fluxing the metal powder and cross-linking the polymer. The composition further comprises a dicarboxylic acid and a monocarboxylic acid for fluxing the metal powder. The composition may be used for forming a conductor. The conductor may be used for current transport and/or electrical connection. As such, the conductor can be useful for a variety of applications, such as being configured as a busbar, a contact pad, an electrode, etc.

The present invention also provides an article including the conductor formed from the invention composition. The article comprises a substrate and the conductor disposed on and in electrical contact with the substrate. The article may be used for various applications, such as for converting light of many different wavelengths into electricity.

### BRIEF DESCRIPTION OF THE DRAWINGS

The present invention may be readily appreciated, as the same becomes better understood by reference to the following detailed description when considered in connection with the accompanying drawings wherein:
Figure 1 is a diagram illustrating the polymers curing and solder reflow of the composition during formation of the conductor;
Figure 2 is a magnified cross-sectional side view of the composition after forming the conductor illustrating polymers after cure, solder after reflow, metal particles, and an inter-metallic layer between the solder and metal particles;
Figure 3A is a front view of an embodiment of the PV cell including a base substrate, a passivation layer, fingers, and a pair of busbars;
Figure 3B is a rear view of the embodiment of the PV cell including the base substrate, a first electrode, and three sets of second electrodes configured as contact pads;
Figure 4 is a partial cross-sectional side view taken along line 4-4 of Figure 3A illustrating an upper doped region of the base substrate, the passivation layer, fingers, and one of the busbars;
Figure 5 is a cross-sectional side view of an embodiment of the PV cell illustrating upper and rear doped regions of a base substrate, a passivation layer, fingers, a busbar, a first electrode, and a set of second electrodes;
Figure 6 is a partial cross-sectional side view taken along line 6-6 of Figure 3B illustrating a rear doped region of the base substrate, the first electrode, and a second electrode;
Figure 7 is a partial cross-sectional side view of an embodiment of the PV cell illustrating a rear doped region of a base substrate, a grid or array of first electrodes, a passivation layer, and a second electrode;
Figure 8 is a partial cross-sectional side view of an embodiment of the PV cell illustrating a rear doped region of a base substrate, a first electrode having localized contacts, a passivation layer, and a second electrode;
Figure 9 is a partial cross-sectional side view of an embodiment of the PV cell illustrating a base substrate having localized rear doped regions, a first electrode having localized contacts, a passivation layer, and a second electrode;
Figure 10 is a partial cross-sectional perspective view of an embodiment of the PV cell illustrating upper and rear doped regions of a base substrate, a passivation layer, fingers, a first electrode, a pair of busbars, and a pair of second electrodes;
Figure 11 is the PV cell of Figure 10 and a pair of tabbing ribbons with one of the tabbing ribbons being disposed on one of the busbars of the PV cell;
Figure 12 is a schematic front view of an embodiment of the PV cell including a passivation layer, discontinuous-fingers, and a busbar;
Figure 13 is a schematic front view of an embodiment of the PV cell including a passivation layer, discontinuous-fingers, supplemental fingers, and a busbar;
Figure 14 is a schematic front view of an embodiment of the PV cell including a passivation layer, fingers, a busbar, and supplemental busbar pads;
Figure 15 is a schematic front view of an embodiment of the PV cell including a passivation layer, fingers, a pair of busbars, and a supplemental busbar;
Figure 16 is a schematic front view of an embodiment of the PV cell including a passivation layer, fingers having pads, and a busbar;
Figure 17 is a schematic front view of an embodiment of the PV cell including a passivation layer, fingers having hollow pads, and a busbar;
Figure 18 is a schematic front view of an embodiment of the PV cell including a passivation layer, discontinuous-fingers, supplemental fingers, and a busbar;
Figure 19A is a schematic rear view of an embodiment of the PV cell including a base substrate, a first electrode defining a hole, and a second electrode disposed over the first electrode and in contact with the base substrate via the hole;
Figure 19B is a schematic side view of the PV cell of Figure 19A;
Figure 20A is a schematic rear view of an embodiment of the PV cell including a base substrate, a first electrode defining a plurality of holes, and a second electrode disposed over the first electrode and in contact with the base substrate via the holes;
Figure 20B is a schematic side view of the PV cell of Figure 20A;
Figure 21 is a schematic rear view of an embodiment of the PV cell including a base substrate; interdigitated fingers, and a pair of busbars;
Figure 22 is a scatter plot illustrating peel force of invention examples on a silicon substrate;
Figure 23 is a scatter plot illustrating peel force of invention examples on an aluminum substrate;
Figure 24 is a scatter plot illustrating resistivity of invention examples;
Figure 25 is a box graph illustrating short-circuit current density (J_{SC}) of comparative and invention examples;
Figure 26 is a box graph illustrating open-circuit voltage (V_{OC}) of comparative and invention examples;
Figure 27 is a box graph illustrating cell efficiency (NCell) of comparative and invention examples;
Figure 28 is a box graph illustrating NCell of comparative and invention examples;
Figure 29 is a box graph illustrating V_{OC} of comparative and invention examples with ethylene vinyl acetate and silicone encapsulants;
Figure 30 is a graph illustrating I-V (or I-U) characteristics of comparative and invention examples with amps (A) and volts (V);
Figure 31A is a cross-sectional SEM micrograph (converted to drawing form) of an invention example illustrating the polymers after cure, the solder after reflow, metal particles, and an inter-metallic layer between the solder and metal particles;
Figure 31B is a cross-sectional SEM micrograph which the drawing of Figure 31A is based;
Figure 32 is a box graph illustrating efficiency percentage of comparative and invention examples;
Figure 33 is another box graph illustrating J_{SC} of comparative and invention examples;
Figure 34 is another box graph illustrating V_{OC} of comparative and invention examples;
Figure 35 is a cross-sectional optical microscopy photograph (converted to drawing form) illustrating a tabbed busbar of the invention, a finger, and a passivation layer;
Figure 36 is a line graph illustrating J_{SC} of comparative and invention examples after damp heat aging;
Figure 37 is a line graph illustrating V_{OC} of comparative and invention examples after damp heat aging; and
Figure 38 is a line graph illustrating sheet resistivity (rs) of comparative and invention examples after damp heat aging.

### DETAILED DESCRIPTION OF THE INVENTION

The present invention provides a composition. The composition generally comprises a metal powder, a solder powder, a polymer, a carboxylated-polymer different from the polymer, a dicarboxylic acid, and a monocarboxylic acid. In further embodiments, the composition consists essentially of, or alternatively consists of, the aforementioned components. In certain embodiments, the composition can further comprise one of more additives, described further below. The composition is useful for forming a conductor. Typically, the conductor is formed by heating the composition, as described further below. The conductor may also be referred to as an electrical conductor, which is electrically conductive. While not limited to a particular configuration or use, the conductor can be in various forms, such as busbars, fingers, pads, dots, and/or other electrode structures. Some of these are described in greater detail hereinafter.

The metal powder can comprise various metals. Typically, the metal powder has a melting temperature (or melting point; MP) that is over about 600, over about 700, over about 800, or over about 900, °C. The metal generally has excellent electrical conductivity. In certain embodiments, the metal powder comprises at least one metal selected from the group of copper (Cu), gold, silver (Ag), zinc, aluminum, platinum, palladium, beryllium, rhodium, nickel, cobalt, iron, molybdenum, tungsten, and/or an alloy of two or more of these metals. In various embodiments, the metal comprises a mixture (or blend) of metal particles (the same as or different from each other), and/or particles comprising two or more different metals. The latter type of particles may be alloys of two or more different metals, and/or coated particles having a core comprising at least one metal and one or more outer layers comprising at least one metal different from the core metal(s). An example of such a coated particle is a silver coated (or plated) copper particle.

In certain embodiments, the composition is substantially to completely free of "heavy" metals. Said another way, the composition typically comprises less than 0.5, less than 0.25, less than 0.1, less than 0.5, approaching zero (0), or 0, weight percent (wt%) heavy metal(s), each based on the total weight of the composition. Examples of heavy metals include mercury, cadmium, lead, and chromium. In certain embodiments, the composition is free of mercury, cadmium, and chromium. In further embodiments, the composition is free of solder powders comprising lead (Pb).

The metal powder may be treated with a stability enhancer and/or surface protectant. Such treatments can include organic chelation agents, such as azoles, e.g. benzotriazole, imidazoles, etc. Generally, decomposition products of such azoles can serve as catalysts for a reaction between the polymer and the carboxylated-polymer to form the conductor from the composition. Such a reaction generally obviates any need for post-curing of the conductor after formation.

In certain embodiments, the metal powder comprises Cu, or is Cu powder. Various types of Cu powder can be utilized. For example, Cu powder may include a surface treatment as described above. The metal powder can be of various sizes. Typically, the metal powder has a particle size of from about 0.05 to about 25, about 5 to about 25, about 5 to about 15, or about 10, µm on average. Various particle size distributions (PSDs) can be utilized, including unimodal, bimodal, or multimodal distributions, with unimodal being typical for fluxing purposes. Suitable Cu powders are commercially available from a variety of suppliers, such as Mitsui Mining & Smelting Co., Ltd., of Japan, e.g. 1030 Cu powder or Y1400 Cu powder.

The solder powder has a lower melting temperature (i.e., melting point) than a melting temperature of the metal powder. Such temperatures for the metal powder are described above. In certain embodiments, the solder powder has a melting temperature of no greater than about 300, no greater than about 275, no greater than about 250, or no greater than about 225, °C.

Typically, the solder powder includes at least one metal selected from the group of tin (Sn), bismuth, zinc, gallium, indium, tellurium, thallium, antimony, selenium, and/or an alloy of two or more of these metals. In various embodiments, the solder powder comprises Sn, or at least one Sn alloy. In certain embodiments, the solder powder comprises two different alloys, alternatively more than two different alloys. For example, the solder powder can comprise a tin-bismuth (SnBi) alloy, a tin-silver (SnAg) alloy, or a combination thereof. The "combination" may simply be a combination of different metals, different alloys, or different metal(s) and alloy(s). In other embodiments, the solder powder may comprise SnPb.

In certain embodiments, the solder powder comprises Sn42/Bi58, Sn96.5/Ag3.5, or a combination thereof. Such alloy nomenclature generally indicates the amount of each metal by mass. Sn42/Bi58 generally has a melting temperature of about 138 °C, and Sn96.5/Ag3.5 generally has a melting temperature of about 221 °C. These alloys may be referred to in the art as "Alloy 281" and "Alloy 121", respectively. Typically, the solder powder has a particle size of from about 0.05 to about 25, about 2.5 to about 25, about 5 to about 20, about 5 to about 15, or about 10, µm on average. Various PSDs, and modes thereof, can be utilized. Suitable solder powders are commercially available from a variety of suppliers, such as Indium Corporation of America of Elk Grove Village, IL.

The solder is useful for suppressing oxidation of the metal powder, especially after formation of the conductor. It is believed that the solder also enhances wetting of supplemental solders and facilitates strong solder joint formation during soldering operations employing the conductor. As described further below, the solder powder, upon melting, generally fuses particles of the metal powder together prior to the composition reaching a final cure state. Such melting and fusing forms electrically conductive bridges in the conductor during formation.

The metal and solder powders can be present in the composition in various amounts. Typically, the metal and solder powders are collectively present in an amount (or a combined amount) of from about 50 to about 95, about 80 to about 95, about 80 to about 90, or about 85, wt%, each based on the total weight of the composition Typically, the metal powder is present in the composition in an individual amount of from about 35 to about 85, about 35 to about 65, about 40 to about 55, about 40 to about 50, or about 45, wt%, each based on the total weight of the composition. Typically, the solder powder is present in the composition in an individual amount of from about 25 to about 75, about 25 to about 55, about 30 to about 50, about 35 to about 45, or about 40, wt%, each based on the total weight of the composition.

The polymer can comprise various types of polymers, or a monomer which is polymerisable to yield the polymer. The polymer is generally a thermosetting resin, such as an epoxy, an acrylic, a silicone, a polyurethane, or combinations thereof. In certain embodiments, the polymer comprises an epoxy resin, which could also be a "B stage" resin. Examples of epoxy resins include diglycidyl ethers of bisphenol A, and diglycidyl ethers of bisphenol F.

In embodiments where the polymer comprises (or is) an epoxy resin, the epoxy resin can be of various epoxide equivalent weights (EEW). In certain embodiments, the epoxy resin has an EEW of from about 20 to about 100,000, about 30 to about 50,000, about 35 to about 25,000, about 40 to about 10,000, about 150 to about 7,500, about 170 to about 5,000, about 250 to about 2,500, about 300 to about 2,000, about 312 to about 1,590, about 400 to about 1,000, or about 450 to about 600, g/eq. EEW may be determined via methods understood in the art, such as by ASTM D1652.

Suitable examples of epoxy resins are commercially available from Dow Chemical of Midland, MI, under the trademark D.E.R.^{™}, such as D.E.R.^{™} 383, 6116, 662 UH, 331, 323, 354, 736, 732, 324, 353, 667E, 668-20, 671-X70, 671-X75, 684-EK40, 6225, 6155, 669E, 660-MAK80, 660-PA80, 337-X80, 337-X90, 660-X80, 661-A80, 671-PM75, 3680-X90, 6510HT, 330, 332, 6224, 6330-A10, 642U, 661, 662E, 663U, 663UE, 664U, 672U, 664UM, 667-20, 669-20, 671-R75, 671-T75, 671-XM75, and/or 692H. Other suitable epoxy resins are commercially available from Huntsman and Momentive under the trademarks Araldite® and Epikote^{™}.

The polymer generally functions as a binder which improves the adherence of the conductor to a substrate after curing, and increases overall cohesive strength of the conductor. In general, the conductor has excellent adhesive and cohesive properties. It is believed that during/after cure, the polymer provides adhesion between the conductor and the substrate at an interface (or interfaces) there between, and also provides cohesion between internal components of the conductor, e.g. the metal powder. The polymer can stick to a variety of difference surfaces, including solderable and non-solderable surfaces. The polymer also presents a portion of the metal powder opposite the substrate interface for direct soldering purposes, e.g. for tabbing. Prior to reaching a final cure state, the polymer also acts as a medium for delivering fluxes to the metal powder, as described further below.

The carboxylated-polymer can comprise various types of polymers and copolymers having one or more carboxyl (-COOH) groups, typically two or more carboxyl groups, such that the conductor generally has a cross-linked structure. The -COOH group (or groups) generally act as flux, are reactive with other groups in the composition (e.g. epoxy groups of the polymer), and/or form salts with metal oxides thus promoting cure (e.g. catalyzing epoxy cure). Examples of these carboxylated-polymers include those resulting from the polymerization or co-polymerization via anionic mechanism or radical mechanism of unsaturated aliphatic or aromatic acids, possibly in combination with unsaturated aliphatic or aromatic hydrocarbons, such as alkenes, alkynes, and/or arylenes. Suitable unsaturated carboxylic acids include aliphatic carboxylic acids, such as methacrylic acid, halogenoacrylic acid, crotonic acid, carboxyethylacrylate, acrylic acid, fumaric acid, itaconic acid, muconic acid, propargylacetic acid, and/or acetylendicarboxylic acid; and unsaturated aromatic acids, such as vinylbenzoic acid and/or phenylpropynoic acid. Suitable unsaturated alkenes in combination with unsaturated acids to form carboxylated copolymers include propylene, isobutylene, vinylchloride, and/or styrene. Other examples of suitable carboxylated-polymers include carboxylic acid functional polyester resins and carboxylic acid anhydrides and polymers made thereof.

The carboxylated-polymer can be of various acid equivalent weights (AEW). In certain embodiments, the carboxylated-polymer has an AEW of from about 20 to about 100,000, about 25 to about 50,000, about 30 to about 25,000, about 30 to about 10,000, about 30 to about 5,000, about 30 to about 2,500, about 30 to about 2,000, about 40 to about 1,000, or about 50 to about 500, g/eq. AEW may be determined via methods understood in the art, such as by dividing molecular weight by the number of carboxyl groups and/or by ASTM D1980 to determine an acid value.

The carboxylated-polymer is useful for fluxing the metal powder and for cross-linking the polymer to form the conductor. Specifically, during heating of the composition to form the conductor, the carboxylated-polymer generally fluxes the metal powder at a first temperature, and serves as a cross-linking agent for the polymer at a second temperature, which is generally higher than the first temperature. These temperatures can vary, but generally fall within the temperature ranges described herein.

While serving as a fluxing agent for the metal powder, the carboxylated-polymer generally dissolves metal oxide on the surface of the metal. Removal of the metal oxide permits the metal particles to group (or agglomerate) and better form conductive bridges in the conductor during formation, especially in the case of solder-Cu bonding. Typically, the metal powder is fluxed in-situ during formation of the conductor, such that pre-fluxing of the metal powder prior to use is not necessary. For example, a pre-fluxer/cleaner, e.g. an acid, is not required to remove oxides from surface of the metal powder prior to use in the composition. In certain embodiments, the invention lacks prefluxer/prefluxing.

Furthermore, the removed metal oxide is generally present in sufficient quantity to catalyze the reaction between the polymer and the carboxyl groups of the carboxylated-polymer at elevated temperatures. The metal oxide can initially be imparted by heating the metal powder, which oxidizes to form oxides. The oxides can react with the carboxylated-polymer to from salts. The oxides and salts can serve as catalysts for the reaction of the polymer and carboxylated-polymer. Additionally catalysts may be made available with the thermal release of chelating agent which may have been used to treat the metal powder(s). Various catalysts can be liberated based on the type of metal and/or solder powder, such as organic tin and copper salts, benzotriazole, imidazole, etc. These various mechanisms generally occur after application of the composition and during formation of the conductor. These mechanisms interrelate to melting, wet-out, fluxing, and cure temperatures or profiles of the composition/components thereof.

In certain embodiments, the carboxylated-polymer comprises an acrylic polymer. In further embodiments, the carboxylated-polymer comprises a styrene-acrylic copolymer. In specific embodiments, the carboxylated-polymer is thermally stable at 215 °C, has an acid number greater than 200, and/or a viscosity of less than 0.01 Pa.s (10 centipoise) at 20 °C. Examples of suitable acrylic polymers are commercially available from BASF Corp. of Florham Park, NJ, under the trademark Joncryl®, such as Joncryl® 50, 60, 61, 63, 67, 74-A, 77, 89, 95, 142, 500, 504, 507, 508, 510, 530, 537, 538-A, 550, 551, 552, 556, 558, 581, 585, 587, 611, 624, 631, 633, 646, 655, 660, 678, 680, 682, 683, 690, 693, 690, 693, 750, 804, 815, 817, 819, 820, 821, 822, 843, 845, 848, 901, 902, 903, 906, 906-AC, 909, 911, 915, 918, 920, 922, 924, 934, 935, 939, 942 ,945, 948, 960, 963, 1163, 1520, 1522, 1532, 1536, 1540, 1610, 1612, 1655, 1670, 1680, 1695, 1907, 1908, 1915, 1916, 1919, 1954, 1980, 1982, 1984, 1987, 1992, 1993, 2153, 2178, 2350, 2561, 2570, 2640, 2646, 2660, 2664, 8383, and/or HR 1620.

Typically, the polymer and the carboxylated-polymer are collectively present in the composition an amount of from about 2.5 to about 10, about 2.5 to about 7.5, about 3 to about 6, about 5 to about 6, or about 5.5, wt%, each based on the total weight of the composition. In certain embodiments, the polymer and carboxylated-polymer are in a weight ratio of from about 1:1 to about 1:3, about 1:1 to about 1:2.75, about 1:1 to about 1:2.5, or about 1:1.5 to about 1:2.5, (polymer:carboxylated-polymer).

Typically, the polymer is present in the composition an amount of from about 0.5 to about 5, about 1 to about 2.5, about 1.5 to about 2, or about 1.75, wt%, each based on the total weight of the composition. Typically, the carboxylated-polymer is present in the composition an amount of from about 1 to about 7.5, about 2 to about 5, about 3 about 4, or about 3.5 to about 4, wt%, each based on the total weight of the composition.

The dicarboxylic acid is also useful for fluxing the metal powder, in addition to the carboxylated-polymer. Various types of dicarboxylic acids can be utilized. Examples of suitable dicarboxylic acids include linear, cyclic, aromatic and/or highly branched alkyl and/or unsaturated aliphatic and/or aryl dicarboxylic acid such as oxalic acid, malonic acid, succinic acid, glutaric acid, adipic acid, pimelic acid, suberic acid, azelaic acid, sebacic acid, undecanedioic acid, dodecanedioic acid, maleic acid, glutaconic acid, traumatic acid, muconic acid, phthalic acid, isophthalic, and/or terephthalic acid. In certain embodiments, the dicarboxylic acid is dodecanedioic acid (DDDA). Typically, the dicarboxylic acid is present in the composition in an amount of from about 0.05 to about 1, about 0.1 to about 0.75, about 0.2 to about 0.5, or about 0.2 to about 0.3, wt%, each based on the total weight of the composition.

The monocarboxylic acid is also useful for fluxing the metal powder, in addition to the carboxylated-polymer and the dicarboxylic acid. Specifically, the monocarboxylic is useful for preventing premature cure of the composition from metal oxides that may be already present or formed at ambient temperature. Various types of monocarboxylic acids can be utilized. Examples of suitable monocarboxylic acids include linear, cyclic, aromatic and/or highly branched alkyl and/or unsaturated aliphatic and/or aryl monocarboxylic acids such as formic acid, acetic acid, halogenoacetic acid, propionic acid, butyric acid, valeric acid, caproic acid, caprylic acid, lauric acid, decanoic acid, palmitic acid, stearic acid, icosanoic acid, isobutyric acid, isopentanoic acid, neopentanoic acid, neodecanoic acid, isostearic acid, oleinic acid, nervonic acid, linoleic acid octynoic acid, benzoic acid, and/or phenylpropynoic acid. In various embodiments, the monocarboxylic acid is a versatic acid. In certain embodiments, the monocarboxylic acid is Versatic 10, which is a synthetic acid comprising a mixture of highly branched isomers of C₁₀ monocarboxylic acids, mostly of tertiary structure. Versatic 10 may also be referred to in the art as neodecanoic acid. Examples of suitable monocarboxylic acids are commercially available from Hexion Specialty Chemicals of Carpentersville, IL.

It is believed that the high degree of branching in the monocarboxylic acid gives rise to steric hindrance which imparts salts formed therefrom with excellent stability. In certain embodiments, the monocarboxylic acid is liquid at room temperature (RT; ~20 to 25 °C). Typically, the monocarboxylic acid is present in the composition an amount of from about 0.25 to about 1.25, about 0.25 to about 1, about 0.25 to about 0.75, about 0.4 to about 0.5, or about 0.45, wt%, each based on the total weight of the composition.

In embodiments where the polymer comprises an epoxy resin such that epoxy groups are provided, the ratio of acidic groups (provided by the acids) to epoxy groups is generally of from about 1:1 to about 10:1, about 2:1 to about 9:1, about 3:1 to about 8:1, about 4:1 to about 7:1, about 5:1 to about 7:1, or about 6:1 to about 7:1, acidic:epoxy (A:E). In further embodiments, the ratio of acidic groups to epoxy groups is generally at least about 3:1, at least about 3.5:1, at least about 4:1, at least about 4.5:1, at least about 5:1, at least about 5.5:1, at least about 6:1, at least about 6.5:1, or at least about 7:1, A:E.

Without being bound or limited to any particular theory, it is believed that increasing the A:E ratio, e.g. above about 4:1, provides for excellent fluxing of the metal powder without the need for pre-fluxing of the metal powder. At lower ratios, e.g. less than about 4:1 A:E, it is believed that the composition will not be directly solderable due to insufficient fluxing of the metal powder. Specifically, in certain embodiments, at a A:E below about 4:1, fluxing may not occur, which can be determined via color change during heating/cure. In addition, at such lower levels, the solder powder may not wet out and/or be solderable, even with fluxing. Generally, a color change (or shift) from brown to light to dark grey indicates sufficient fluxing or fluxed materials. As such, if the material remains brown (or brown like, e.g. coppery colored) after attempting to flux the material, then fluxing did not occur or was insufficient. It is believed that the material turns grey after fluxing due to wetting out of the metal powder, e.g. Cu, surface with the solder such that you effectively only see the solder. In situations where fluxing is insufficient, the surface of metal powder is not completely wet out with the solder such that it is still visible.

In certain embodiments, the composition can further comprise an additive. Various types of additives can be utilized. Examples of suitable additives include solvents, adhesion promoters, defoamers, deactivators, anti-oxidants, rheology enhancers/modifiers, and/or thermal agents. Further examples of suitable components, useful for forming various embodiments of the composition, are disclosed in U.S. Patent No. 7,022,266 to Craig, and in U.S. Patent No. 6,971,163 to Craig et al., both of which are incorporated herein by reference in their entirety to the extent they do not conflict with the general scope of the invention.

If utilized, solvents can be useful for cutting the polymer and/or carboxylated-polymer into solution. Solvents can also be useful for adjusting viscosity of one or more of the components, and/or for adjusting rheology of the composition itself. Adjusting viscosity of the composition can be useful for various purposes, e.g. for obtaining a desired viscosity should the composition be applied via printing or similar technique. Various types of solvents can be utilized. Examples of suitable solvents include alcohols, such as monoterpene alcohol (e.g. terpineol), and benzyl alcohol. Further examples include 2-ethoxyethyl acetate, 2(3)-(Tetrahydrofurfuryloxy)tetrahydropyran, diisobutyl ketone, propylene glycol monomethyl ether acetate (PGMEA) and propylene glycol-1,2 propanediol. Such solvents are commercially available from various sources, such as Sigma Aldrich of Chicago, IL. Another suitable solvent is butyl carbitol, which is commercially available from Dow Chemical. Various combinations of solvents can be utilized. The solvent can be used in various amounts. In certain embodiments, the solvent(s) is present in the composition in an amount of from about 0.5 to about 15, about 1 to about 12.5, about 2.5 to about 10, about 5 to about 7.5, or about 5 to about 7, wt%, each based on the total weight of the composition. Depending on application technique, the solvent may be added in a predetermined amount and/or added as needed.

If utilized, adhesion promoters are useful for further increasing adhesion of the conductor on various substrates. Various types of adhesion promoters can be utilized. Examples of suitable adhesion promoters (or coupling agents) include those based on silane and/or titanate. Employing silane adhesion promoters is useful for increasing adhesion to substrates having organic functionalities. Employing titanate adhesion promoters is useful for increasing adhesion to substrates having inorganic fillers. It is believed that the titanate coupling agent couples to the surface of inorganic fillers to improve the compatibility with an organic matrix and also improves adhesion to the substrate. A combination of different promoters can be used. In certain embodiments, the adhesion promoter, e.g. titanate, is reactive with at least one of the polymers of the composition. Examples of suitable adhesion promoters are commercially valuable from Dow Corning Corp. of Midland, MI, such as 2-(3,4-epoxycyclohexyl)ethyl]trimethoxysilane, e.g. Z-6043, or glycidoxypropyltrimethoxysilane, e.g. Z-6040. Further suitable examples include those commercially available from Momentive under the trademark Silquest, such as Silquest A-187; from Xiameter, such as Xiameter® OFS-6040; and from Kenrich Petrochemicals Co. of Bayonne, NJ, under the trademark Ken-React®, such as Ken-React® KR9S. While not required, the adhesion promoter can be used in various amounts. In certain embodiments, the adhesion promoter(s) is present in the composition in an amount of from about 0.01 to about 3, about 0.1 to about 2, about 0.25 to about 1, or about 0.8, wt%, each based on the total weight of the composition.

If utilized, defoamers are useful for preventing foaming during formation and/or use of the composition. Various types of defoamers can be utilized. Examples of suitable defoamers include silicone-free defoamers. Examples of suitable defoamers are commercially available from BYK additives & instruments of Wallingford, CT, such as BYK®-052. While not required, the defoamer can be used in various amounts. In certain embodiments, the defoamer(s) is present in the composition in an amount of from about 0.01 to about 1, about 0.1 to about 0.75, about 0.1 to about 0.5, or about 0.1 to about 0.3, wt%, each based on the total weight of the composition.

If utilized, deactivators and/or anti-oxidants are useful for suppressing migration of metals, e.g. Cu. Various types of deactivators and/or anti-oxidants can be utilized. In one embodiment, the deactivator comprises oxalyl bis(benzylidenehydrazide). Examples of suitable deactivators and/or anti-oxidants are commercially available from Eastman Chemical Co. of Kingsport, TN, such as Eastman^{™} OABH Inhibitor. While not required, the deactivator and/or anti-oxidant can be used in various amounts. In certain embodiments, the deactivator(s) is present in the composition in an amount of from about 0.01 to about 1, about 0.1 to about 0.75, about 0.1 to about 0.5, or about 0.1 to about 0.4, wt%, each based on the total weight of the composition.

In certain embodiments, the composition comprises a styrene dibromide. A specific example is 1,2 dibromoethyl benzene, which is commercially available from Sigma Aldrich. The styrene dibromide is useful for increasing thermal conductivity of the composition. In addition, the presence of a vinyl functional group allows the styrene to polymerize during formation of the conductor. While not required, the styrene dibromide can be used in various amounts. In certain embodiments, the styrene dibromide is present in the composition in an amount of from about 0.05 to about 1, about 0.1 to about 0.75, about 0.1 to about 0.5, or about 0.2 to about 0.3, wt%, each based on the total weight of the composition.

Referring now to the Figures, wherein like numerals indicate like parts throughout the several views, the composition is generally shown at **20"** and the conductor formed therefrom is generally shown at **20**. As used herein, a quotation mark (") generally indicates a different state of the respective component or composition, such as prior to curing, prior to sintering, etc., whereas lack of the " generally indicates a post or final cure state of the respective component or composition.

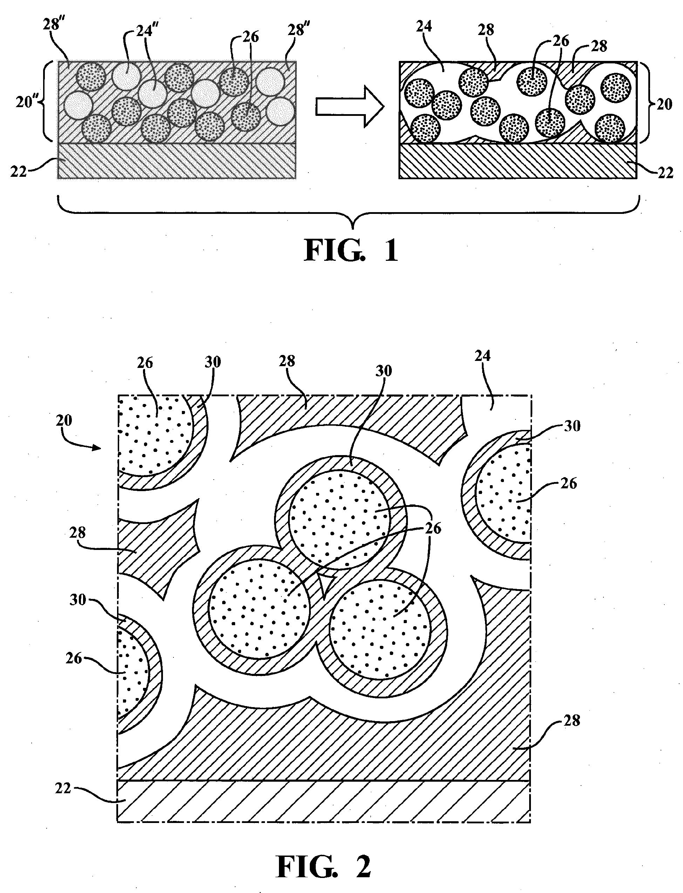

Referring to Figure 1, the composition **20**" is disposed on a substrate **22** and is generally shown "pre-cured" on the left, and "cured" on the right such that it is the conductor **20**. As alluded to above, the conductor **20** is useful for current transport and/or electrical connections for a variety of applications. The composition **20"** and conductor **20** is not limited to any particular application. The composition **20"** can be used to form various articles. Such articles generally include a substrate **22** with the conductor **20** disposed on the substrate **22**. The substrate **22** can be formed from various materials. In one embodiment, the substrate **22** is also a conductor itself. Examples of such conductive substrates **22** include metals and semi-conductors. Specific examples of metal substrates **22** include aluminum, silver, or combinations thereof. Examples of semi-conductor substrates **22** include those formed from silicon, such as crystalline silicon. In other embodiments, the substrate **22** is a dielectric (or insulator). The composition **20"** can be disposed on a variety of materials, including combinations of those described above. Examples of other specific materials include both solderable and non-solderable metals, such as high melting point conductive metals, e.g. nickel or a conventional bulk substrate. In general, only metallic materials are considered to be solderable.

The conductor **20** can take various forms, and be of various sizes and shapes, such as being configured for use as a busbar, a contact pad, a fine line, a finger, and/or an electrode. For example, the composition **20"** can be used to form fine lines, e.g. 70 µm lines, dots, dots and lines, etc., by printing or other means. Other widths can also be formed. The conductor **20** is not limited to any particular shape or configuration. Some of the aforementioned components are useful for photovoltaic (PV) cells and other PV devices, which are described further below. The composition **20"** can be for other applications as well, such as for circuit boards, e.g. printed circuit board (PCB) production, or other applications requiring a conductive material. The conductor **20** is directly solderable, which provides improved connection means, such as by using tabbing to directly connect to the conductor **20**. Said another way, typically there is no topcoat, protective, or outermost layer which needs to be removed from the conductor **20** prior to soldering directly thereto. This provides for reduced manufacturing time, complexity, and cost. For example, tabbing **52** can be directly soldered to the conductor **20** without the need for additional steps to be taken. In certain embodiments, an exception to this may be an additional fluxing step. In general, a surface is directly solderable if solder can be wet out on the surface after processing. For example, if one can either directly solder a wire to a substrate (within a commercially reasonable time frame and typically using an applied flux), use a tinned soldering iron to place a solder layer on the busbar, or simply heat up the substrate and see the solder wet out the electrode surface, the material would be directly solderable. In the case of a non-solderable system, even after applying flux and extensive heating, the solder never wets the surface, and no solder joint can be made.

In certain embodiments, the composition **20"** can be used as an adhesive by relying on its curing mechanism to form the conductor **20**. For example, the composition 20" can be applied and heated to form the conductor **20**, and the conductor **20** can serve as an adhesive, such as holding a wire in place, holding two substrates together, etc. The wire can be disposed in the composition **20"** and/or the composition **20"** can be disposed on the wire, and subsequently cured to form the conductor **20**, thereby holding the wire in place. Prior to final cure to form the conductor **20**, the instant or intermediate adhesion strength provided by the composition **20"** may be referred to as green strength.

Further embodiments of various types of PV cells **32** utilizing the invention composition to form one or more structures/components thereof, such as busbars formed from the invention composition, are described in co-pending PCT Application No. ______ (Attorney Docket No. DC11371 PSP1; 071038.01087), and in co-pending PCT Application No. __________ (Attorney Docket No. DC11372 PSP1; 071038.01089), both filed concurrently with the subject application, the disclosures of which are incorporated by reference in their entirety to the extent they do not conflict with the general scope of the present invention.

The present invention also provides a method of forming the conductor **20**. The method includes the step of applying the composition **20"** to the substrate **22**. The composition **20"** can be applied by various methods. Various types of deposition methods can be utilized, such as printing through screen or stencil, or other methods such as aerosol, ink jet, gravure, or flexographic, printing. In certain embodiments, the composition **20"** is screen printed directly onto the substrate **22**. The composition **20"** is generally in the form of a paste, as such, printing is one method that can readily be utilized. As introduced above, solvent(s) can be utilized to adjust print viscosity of the composition **20"**, if needed. The composition **20"** can be applied to the substrate **22** to make direct physical and electrical contact to the substrate **22**.

As described above, the solder powder **24"** of the composition **20"** melts at lower temperature than melting temperature of the metal powder **26** of the composition **20"**. The composition **20"** further comprises the polymers and other components **28"** described above. The method further comprises the step of heating the composition **20"** to a temperature of no greater than about 300 °C to form the conductor **20**. The composition **20"** is generally heated to a temperature of from about 150 to about 300, about 175 to about 275, about 200 to about 250, about 200 to about 225, about 210 to about 225, or about 225, °C. In certain embodiments, the composition **20"** is heated at about 250, about 225, or about 210, °C or less to form the conductor **20**. In certain embodiments, the composition **20"** is heated to a temperature of from about 200 to about 300 °C, or any temperature there between. These temperatures generally sinter the solder powder **24"**, but do not sinter the metal powder **26**, to form the conductor **20**. Such heating may also be referred to in the art as reflow or sintering.

Referring to Figures 1 and 2, it is believed that the solder powder **24"** sinters and coats particles of the metal powder **26** during heating of the composition **20"** to form the conductor **20**. Also during this time, the composition **20"** can lose volatiles and the polymers **28"** crosslink to a final cured state **28**, generally providing adhesion to the substrate **22**. As shown in Figure 2, at least a portion of the polymer **28** is in direct contact with the substrate **22**. An inter-metallic layer **30** generally forms around particles of the metal powder **26**. Such coating enables the solder **24** coated particles of metal powder **26** to carry current, and can also prevent oxidation of metal powder **26**. Due to the lower temperatures, the metal powder **26** does not generally sinter during the heating. The low temperature of this heating step generally allows for the use of temperature sensitive substrates **22**, e.g. amorphous silicon or transparent conductive oxides.

The composition **20"** can be heated for various amounts of time to form the conductor 20. Typically, the composition **20"** is heated only for the period of time required for the conductor **20** to form. Such times can be determined via routine experimentation. An inert gas, e.g. a nitrogen (N₂) gas blanket, can be used to prevent premature oxidation of the metal powder **26** prior to being coated with the solder **24"**. However, pre-fluxing of the metal powder **26** is generally not required. Unnecessarily overheating the conductor **20** for longer periods of time may damage the substrate **22** and/or the conductor **20**.

Without being bound or limited by any particular theory, it is believed that the composition **20"** is generally self fluxing and oxidation resistant based on the following mechanism: heat onset activates the carboxylated-polymer to flux the solder and metal powders **24"**,**26**. Released metallic oxides and salts, act as a catalyst and promote rapid cross linking between the polymer and the carboxylated-polymer at a higher temperature. The catalyzing oxides evolve from native metal, e.g. Cu, oxidation. The metallic salts are either produced from the reaction between the oxides and the carboxylated-polymer or are compounds used as lubricants/stability enhancers which have been released as a result of the solder and metal powders **24"**,**26** heating. In addition to the fluxing/cross-linking mechanisms, as the temperature increases, the solder powder **24"** melts and wets the particles of metal powder **26** and a sintering between the metal powder **26** and the solder powder **24** occurs as shown in Figure 1 to form the inter-metallic layer **30**. The solder coating **24** on the particles of the metal powder **26** is beneficial for preventing further oxidation of the metal powder **26** and maintaining conductivity of the conductor **20** over time.

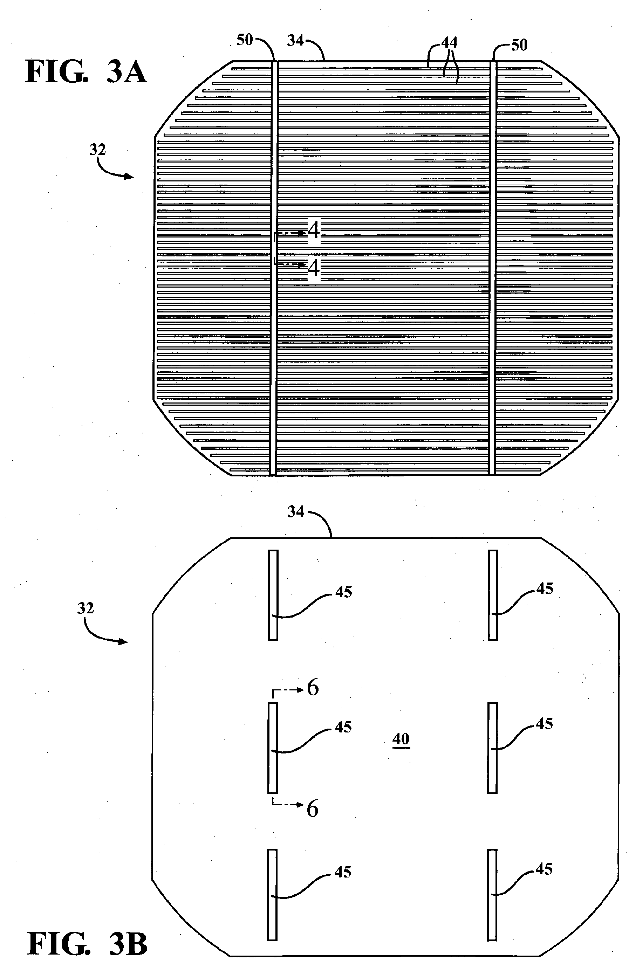

Referring now to the Figures 3 through 11, a photovoltaic (PV) cell is generally shown at **32**. As alluded to above, the composition **20"** can be used with PV cells **32**. Specifically, the composition **20"** and resulting conductor **20** can be used with any type of PV cell, PV construct, or PV configuration. Said another way, the composition **20"** is not limited to any particular type of PV application. PV cells **32** are useful for converting light of many different wavelengths into electricity. As such, the PV cell **32** can be used for a variety of applications. For example, a plurality of PV cells **32** can be used in a solar module (not shown). The solar module can be used in a variety of locations and for a variety of applications, such as in residential, commercial, or industrial, applications. For example, the solar module can be used to generate electricity, which can be used to power electrical devices (e.g. lights and electric motors), or the solar module can be used to shield objects from sunlight (e.g. shield automobiles parked under solar modules that are disposed over parking spaces). The PV cell **32** is not limited to any particular type of use. The figures are not drawn to scale. As such, certain components of the PV cell **32** may be larger or smaller than as depicted.

Referring to Figure 3, the PV cell **32** is shown in a square configuration with rounded corners, i.e., a pseudo-square. While this configuration is shown, the PV cell **32** may be configured into various shapes. For example, the PV cell **32** may be a rectangle with corners, a rectangle with rounded or curved corners, a circle, etc. The PV cell **32** is not limited to any particular shape. The PV cell **32** can be of various sizes, such as 4 by 4 inch (10.2 by 10.2 cm) squares, 5 by 5 inch (12.7 by 12.7 cm) squares, 6 by 6 inch (15.2 by 15.2 cm) squares, etc. The PV cell **32** is not limited to any particular size.

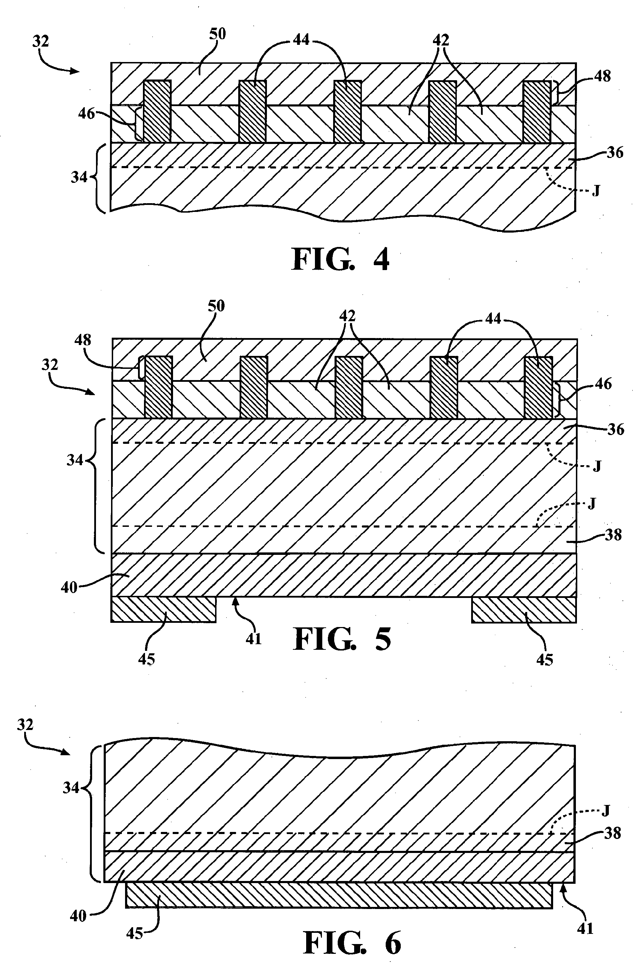

Referring to Figure 4, the PV cell **32** comprises a base substrate **34**. The base substrate **34** comprises silicon. The silicon may also be referred to in the art as a semiconductor material. Various types of silicon can be utilized, such as monocrystalline silicon, polycrystalline silicon, amorphous silicon, or combinations thereof. In certain embodiments, the base substrate **34** comprises crystalline silicon, e.g. monocrystalline silicon. The PV cell **32** is generally referred to in the art as a wafer type PV cell **32**. Wafers are thin sheets of silicon that are typically formed from mechanically sawing the wafer from a single (mono) crystal or multicrystal silicon ingot. Alternatively, wafers can be formed from casting silicon, from epitaxial liftoff techniques, pulling a silicon sheet from a silicon melt, etc.

The base substrate **34** is generally planar, but may also be non-planar. The base substrate **34** can include a textured surface (not shown). The textured surface is useful for reducing reflectivity of the PV cell **32**. The textured surface may be of various configurations, such as pyramidal, inverse pyramidal, random pyramidal, isotropic, etc. Texturing can be imparted to the base substrate **34** by various methods. For example, an etching solution can be used for texturing the base substrate **34**. The PV cell **32** is not limited to any particular type of texturing process. The base substrate **34**, e.g. wafer, can be of various thicknesses, such as from about 1 to about 1000, about 75 to about 750, about 75 to about 300, about 100 to about 300, or about 150 to about 200, µm thick on average.

The base substrate **34** is typically classified as a p-type or an n-type, silicon substrate (based on doping). In certain embodiments, the base substrate **34** includes an upper (or front side) doped region **36**, which is generally the sun up/facing side. The upper doped region **36** may also be referred to in the art as a surface emitter, or active semiconductor, layer. In certain embodiments, the upper doped region **36** of the base substrate **34** is an n-type doped region **36** (i.e., an n⁺ emitter layer) such that a remainder of the base substrate **34** is generally p-type. In other embodiments, the upper doped region **36** of the base substrate **34** is a p-type doped region **36** (i.e., a p⁺ emitter layer) such that a remainder of the base substrate **34** is generally n-type. The upper doped region **36** can be of various thicknesses, such as from about 0.1 to about 5, about 0.3 to about 3, or about 0.4, µm thick on average. The upper doped region **36** may be applied such that doping under the fingers **44** (described below) is increased, such as in "selective emitter" technologies.

Referring to Figures 5 through 9, the base substrate **34** typically includes a rear doped region **38** opposite the upper doped region **36** (if present). The rear doped region **38** may also be referred to as a rear side doped region **38**. In certain embodiments, the rear doped region **38** may also be referred to in the art as a back surface field (BSF). Typically, one of the doped regions, e.g. the upper **36**, is an n-type and the other doped region, e.g. the rear **38**, is a p-type. The opposite arrangement may also be used, i.e., the upper **36** is a p-type and the rear **38**, is an n-type. Such configurations, where the oppositely doped region **36**,**38** interfaces, are referred to in the art as p-n junctions (**J**) and are useful for photo-excited charge separation provided there is at least one positive (p) region and one negative (n) region. Specifically, when two regions of different doping are adjacent, a boundary defined there between is generally referred to in the art as a junction. When the doping are of opposite polarities then the junction (**J**) is generally referred to as a p-n junction (**J**). When doping is merely of different concentrations, the "boundary" may be referred to as an interface, such as an interface between like regions, e.g. p and p⁺ regions. As shown generally in the Figures, such junctions (**J**) may be optional, depending on what type of doping is utilized in the base substrate **34**. The PV cell **32** is not limited to any particular number or location of junction(s) (**J**). For example, the PV cell **32** may only include one junction (**J**), such as on the front or rear.

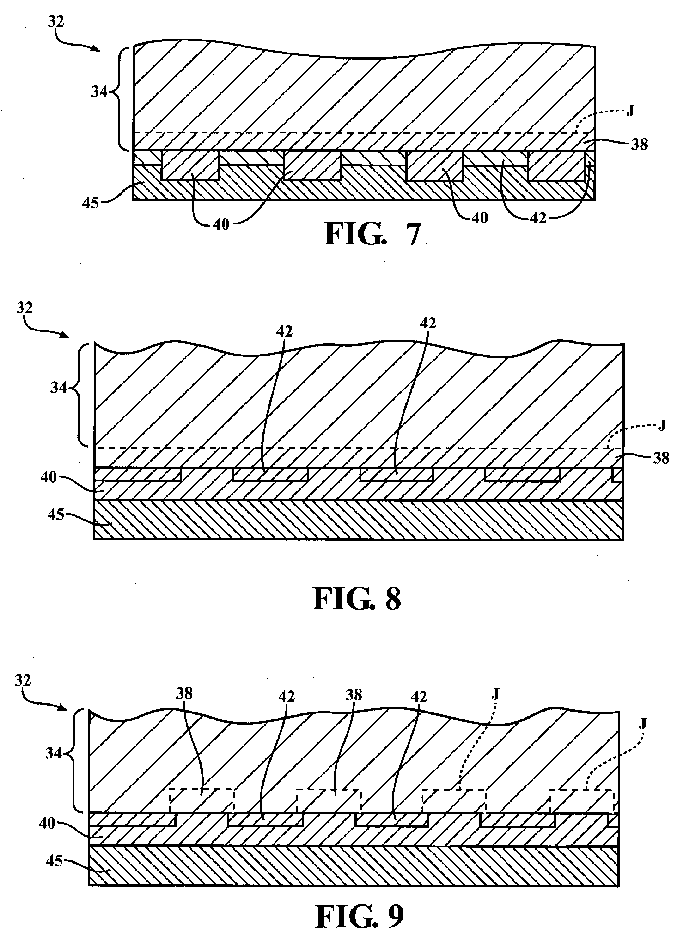

Referring to Figures 5 through 8, the base substrate **34** includes an n-type or p-type rear doped region **38**. Referring to Figure 9, the base substrate **34** includes localized doped regions **38**. In certain embodiments, the localized doped regions **38** are n-type; while in other embodiments, the regions **38** are p-type.

Various types of dopants and doping methods can be utilized to form the doped regions **36**,**38** of the base substrate **34**. For example, a diffusion furnace can be used to form an n-type doped region **36**,**38** and a resulting n-p (or "p-n") junction (**J**). An example of a suitable gas is phosphoryl chloride (POCl₃). In addition or alternate to phosphorus, arsenic can also be used to form n-type regions **36**,**38**. At least one of the periodic table elements from group V, e.g. boron or gallium, can be used to form p-type regions **36**,**38**. The PV cell **32** is not limited to any particular type of dopant or doping process.

Doping of the base substrate **34** can be at various concentrations. For example, the base substrate **34** can be doped at different dopant concentrations to achieve resistivity of from about 0.5 to about 10, about 0.75 to about 3, or about 1, Ω•cm (Ω.cm). The upper doped region **36** can be doped at different dopant concentrations to achieve sheet resistivity of from about 50 to about 150, or about 75 to about 125, or about 100, Q/□ (Ω per square). In general, a higher concentration of doping may lead to a higher open-circuit voltage (V_{OC}) and lower resistance, but higher concentrations of doping can also result in charge recombination depleting cell performance and introduce defect regions in the crystal.

Typically, there is a first electrode **40** disposed on the rear doped region **38**, opposite the upper doped region **36** (if present). The first electrode **40** has an outer surface **41**. The first electrode **40** may cover the entire rear doped region **38** or only a portion thereof. If the later, typically a passivation layer **42,** e.g. a layer of SiN_{X}, is used to protect exposed portions of the rear doped region **38**, but the passivation layer **42** is not used between the first electrode **40** and the portion of rear doped region **38** in direct physical and electrical contact. The first electrode **40** may take the form of a layer, a layer having localized contacts, or a contact grid comprising fingers and busbars. Examples of suitable configurations include, but are not limited to, p-type base configurations, n-type base configurations, PERC or PERL type configurations, bifacial BSF type configurations, heterojunction with intrinsic thin layer (HIT) configurations, emitter wrap through (EWT) configurations, metal wrap through (MWT) configurations, interdigitated back contact (IBC) configurations, etc. The PV cell **32** is not limited to any particular type of first electrode **40** or electrode configuration.

The first electrode **40** may take the form of a layer (e.g. Figs. 5 and 6), a layer having localized contacts (e.g. Figs. 8 and 9), or a contact grid comprising fingers, dots, pads, and/or busbars (e.g. Fig. 7). Examples of suitable configurations include p-type base configurations, n-type base configurations, PERC or PERL type configurations, bifacial BSF type configurations, heterojunction with intrinsic thin layer (HIT) configurations, etc. The PV cell **32** is not limited to any particular type of electrode **40** or electrode configuration. The first electrode **40** can be of various thicknesses, such as from about 0.1 to about 500, about 1 to about 100, or from about 5 to about 50, µm thick on average. Some of these embodiments, as well as others, are described in detail below.

In certain embodiments, the first electrode **40** comprises a first metal, which is present in (each of) the first electrode(s) **40** in a majority amount. The first metal may comprise various types of metals. In certain embodiments, the first metal comprises Al. In other embodiments, the first metal comprises Ag. In yet other embodiments, the first metal comprises a combination of Ag and Al. By "majority amount", it is generally meant that the first metal is the primary component of the first electrode **40**, such that it is present in an amount greater than any other component that may also be present in the first electrode **40**. In certain embodiments, such a majority amount of the first metal, e.g. Al and/or Ag, is generally greater than about 35, greater than about 45, or greater than about 50, wt%, each based on the total weight of the first electrode **40**.

In embodiments where the rear doped region **38** is a p-type, the first electrode **40** typically comprises at least one of the periodic table elements of group III, e.g. aluminum (Al). Al can be used as a p-type dopant. For example, an Al paste can be applied to the base substrate **34** and then fired to form the first electrode **40**, while also forming the rear p⁺-type doped region **38**. The Al paste can be applied by various methods, such as by a screen printing process. Other suitable methods are described below.

As best shown in Figure 6, a second electrode **45** is spaced from the rear doped region **38** of the base substrate **34**. The rear doped region **38** is free of (direct) physical contact with the second electrode **45**. The second electrode **45** is in electrical contact with the first electrode **40**. The second electrode **45** need only contact a portion of the first electrode **40**, or it can cover an entirety of the first electrode **40**. The first and second electrodes **40**,**45** may be referred to in the art as an electrode stack. The rear doped region **38** is in electrical communication with the second electrode **45** via the first electrode **40**. The second electrode **45** is typically configured in the shape of a pad(s) **45**, contact pad(s) **45**, or busbar(s) **45**. Reference to the second electrode **45** herein can refer to various configurations.

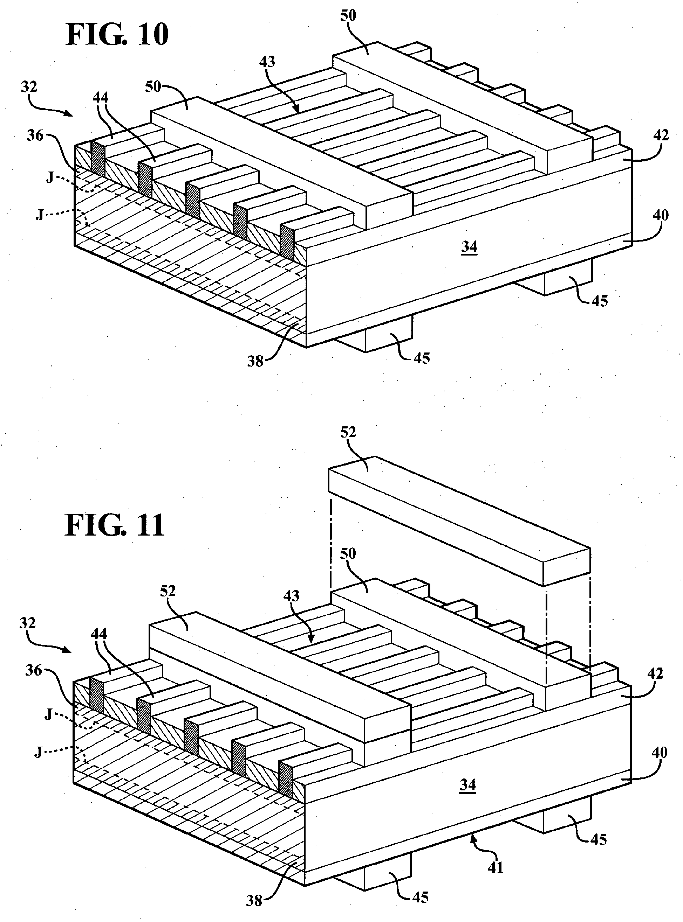

For example, as best shown in Figures 10 and 11, the PV cell **32** can include a pair of second electrodes **45**, shaped as busbars **45**, on the first electrode **40**. In addition, a pair of front busbars **50** is disposed opposite the second electrodes **45** in generally a mirror configuration. The second electrodes **45** and the busbars **50** can be the same or different from each other, both in chemical makeup and/or in physical characteristic, such as shape and size. The busbars **50** are described further below.

As shown in Figures 5, 10 and 11, the PV cell **32** can have two second electrodes **45**. In certain embodiments, the PV cell **20** may have more than two second electrodes **45**, such as three second electrodes **45**, four second electrodes **45**, six second electrodes **45**, etc. Each second electrode **45** is in electrical contact with at least one electrode **40**. The second electrodes **45** are useful for collecting current from the first electrode **40** which has collected current from the rear doped region **38**. As shown generally, the second electrode **45** is disposed directly on the outer surface **41** of the first electrode **40** to provide intimate physical and electrical contact thereto. This places the second electrode **45** in position for carrying current directly from the first electrode **40**. The first electrode **40** is in intimate physical and electrical contact with the rear doped region **38** of the base substrate **34**.

The second electrode **45** can be of various widths, such as from about 0.5 to about 10, about 1 to about 5, or about 2, mm wide on average. The second electrode **45** can be of various thicknesses, such as from about 0.1 to about 500, about 10 to about 250, about 30 to about 100, or about 30 to about 50, µm thick on average. The second electrode **45** can be spaced various distances apart.

The second electrode **45** can be formed from various materials. In one embodiment, the second electrode **45** is formed from the invention composition **20"**, i.e., the conductor **20** is the second electrode **45**. In other embodiments, the second electrode **45** is formed similar to or like to the busbars **50**. The second electrode **45** can be formed in the same manner(s) as described below for the busbars **50**.

As best shown in Figures 4, 5, 10, and 11, the passivation layer **42** is disposed on the upper doped region **36**. The passivation layer **42** is useful for increasing sunlight absorption by the PV cell **32**, e.g. by reducing reflectivity of the PV cell **32**, as well as generally improving wafer lifetime through surface and bulk passivation. The passivation layer **42** has an outer surface **43** opposite the upper doped region **36**. The passivation layer **42** may also be referred to in the art as a dielectric passivation, or anti-reflective coating (ARC), layer.

The passivation layer **42** may be formed from various materials. In certain embodiments, the passivation layer **42** comprises SiO_{X}, ZnS, MgF_{X}, SiN_{X}, SiCN_{X}, AlO_{X}, TiO₂, a transparent conducting oxide (TCO), or combinations thereof. Examples of suitable TCOs include doped metal oxides, such as tin-doped indium oxide (ITO), aluminum-doped zinc-oxide (AZO), indium-doped cadmium-oxide, fluorine-doped tin oxide (FTO), or combinations thereof. In certain embodiments, the passivation layer **42** comprises SiN_{X}. Employing SiN_{X} is useful due to its excellent surface passivation qualities. Silicon nitride is also useful for preventing carrier recombination at the surface of the PV cell **32**.

The passivation layer **42** may be formed from two or more sub-layers (not shown), such that the passivation layer **42** may also be referred to as a stack. Such sub-layers can include a bottom ARC (B-ARC) layer and/or a top ARC (T-ARC) layer. Such sub-layers can also be referred to as dielectric layers, and be formed from the same or different material. For example, there may be two or more sub-layers of SiN_{X}; a sub-layer of SiN_{X} and a sub-layer of AlO_{X}; etc.

The passivation layer **42** can be formed by various methods. For example, the passivation layer **42** can be formed by using a plasma-enhanced chemical vapor deposition (PECVD) process. In embodiments where the passivation layer **42** comprises SiN_{X}, silane, ammonia, and/or other precursors can be used in a PECVD furnace to form the passivation layer **42**. The passivation layer **42** can be of various thicknesses, such as from about 10 to about 150, about 50 to about 90, or about 70, nm thick on average. Sufficient thickness can be determined by the refractive indices of the coating material and base substrate **34**. The PV cell **32** is not limited to any particular type of coating process.

In certain embodiments, a plurality of fingers **44** are spaced from each other and disposed in the passivation layer **42**. Each of the fingers **44** has a lower portion **46** in electrical contact with the upper doped region **36** of the base substrate **34**. The lower portion **46** in actual electrical contact may be quite small, such as tips/ends of the fingers **44**. Each of the fingers **44** also has an upper portion **48** opposite the lower portion **46** extending outwardly through the outer surface **36** of the passivation layer 42. The fingers **44** are generally disposed in a grid pattern, as best shown in Figures 1 and 4. Typically, the fingers **44** are disposed such that the fingers **44** are relatively narrow while being thick enough to minimize resistive losses. Orientation and number of the fingers **44** may vary.

The fingers **44** can be of various widths, such as from about 10 to about 200, about 70 to about 150, about 90 to about 120, or about 100, µm wide on average. The fingers **44** can be spaced various distances apart from each other, such as from about 1 to about 5, about 2 to about 4, or about 2.5, mm apart on average. The fingers **44** can be of various thicknesses, such as from about 5 to about 50, about 5 to about 25, or about 10 to about 20, µm thick on average.

In certain embodiments, one of more of the fingers **44** are formed from the invention composition **20"**, i.e., the conductors **20** are the fingers **44**. In other embodiments, each of the fingers **44** comprises a first metal, which is present in each of the fingers **44** in a majority amount. The first metal may comprise various types of metals. In certain embodiments, the first metal comprises silver (Ag). In other embodiments, the first metal comprises copper (Cu). By "majority amount", it is generally meant that the first metal is the primary component of the fingers **44**, such that it is present in an amount greater than any other component that may also be present in the fingers **44**. In certain embodiments, such a majority amount of the first metal, e.g. Ag, is generally greater than about 35, greater than about 45, or greater than about 50, wt%, each based on the total weight of the finger **44**.

The fingers **44** can be formed by various methods. Suitable methods include sputtering; vapor deposition; strip or patch coating; ink-jet printing, screen printing, gravure printing, letter printing, thermal printing, dispensing or transfer printing; stamping; electroplating; electroless plating; or combinations thereof. Such methods can also be used to form the conductor **20** from the composition **20"**. One type of method is generally referred to as an etching/firing process. In addition to the invention composition **20"**, other compositions for forming the fingers **44** are described further below.

In certain embodiments, the fingers **44** are formed by a plating process (rather than an etching/firing process). In these embodiments, the fingers **44** generally comprise a plated or stacked structure (not shown). For example, the fingers **44** can comprise two or more of the following layers: nickel (Ni), Ag, Cu, and/or Sn. The layers can be in various orders, provided the Cu layer (if present) is not in direct physical contact with the upper doped region **36** of the base substrate **34**. Typically, a seed layer comprising Ag or a metal other than Cu, e.g. Ni, is in contact with the upper doped region **36**. In certain embodiments, the seed layer comprises Ni silicide. Subsequent layers are then disposed on the seed layer to form the fingers **44**. When the fingers **44** include Cu, a passivation layer such as Sn or Ag is disposed over the Cu layer to prevent oxidation. In certain embodiments, the lower portions **46** of the fingers **44** comprise Ni, the upper portions **48** of the fingers **44** comprise Sn, and Cu is disposed between the Ni and Sn. In this way, the Cu is protected from oxidation by the Ni, Sn, and surrounding passivation layer **42**. Such layers can be formed by various methods, such as aerosol printing and firing; electrochemical deposition; etc. The PV cell **32** is not limited to any particular type of process of forming the fingers **44**.

A busbar **50** is spaced from the upper doped region **36** of the base substrate **34**. As shown in Figures 3, 10, and 11, the PV cell **32** generally has two busbars **50**. In certain embodiments, the PV cell **32** may have more than two busbars **50** (not shown), such as three busbars **50**, four busbars **50**, six busbars **50**, etc. Each busbar **50** is in electrical contact with the upper portions **48** of the fingers **44**. The busbars **50** are useful for collecting current from the fingers **44** which have collected current from the upper doped region **36**. As best shown in Figure 10, each of the busbars **50** is disposed on the outer surface **34** of the passivation layer **42** and around each of the fingers **44** to provide intimate physical and electrical contact to the upper portions **48** of the fingers **44**. Typically, the busbar **50** is transverse the fingers **44**. Said another way, the busbar **50** can be at various angles relative to the fingers **44**, including perpendicular. The upper portion **48** in actual physical/electrical contact may be small, such as just tips/ends of the fingers **44**. Such contact places the busbar **50** in position for carrying current directly from the fingers **44**. The fingers **44** themselves are in intimate physical and electrical contact with the upper doped region **36** of the base substrate **34**. Typically, only one junction (**J**) is present in the PV cell **32** of Figure 10, such as in the front or rear of the base substrate **34**.

The busbar **50** can be of various widths, such as from about 0.5 to about 10, about 1 to about 5, or about 2, mm wide on average. The busbar **50** can be of various thicknesses, such as from about 0.1 to about 500, about 10 to about 250, about 30 to about 100 or about 30 to about 50, µm thick on average. The busbars **50** can be spaced various distances apart. Typically, the busbars **50** are spaced to divide lengths of the fingers **44** into ~equal regions, e.g. as shown in Figure 1.

In certain embodiments, one of more of the busbars **50** is/are formed from the invention composition **20**", i.e., the conductors **20** are the busbars **50**. In other embodiments, the busbar **50** comprises a second metal, which is present in the busbar **50** in a majority amount. The "second" is used to differentiate the metal of the busbar **50** from the "first" metal of the fingers **44**, and does not imply quantity or order. The second metal may comprise various types of metals. In certain embodiments, the second metal of the busbar **50** is the same as the first metal of the fingers **44**. For example, both the first and second metals can be Cu. In other embodiments, the second metal of the busbar **50** is different from the first metal of the fingers **44**. In these embodiments, the first metal typically comprises Ag and the second metal typically comprises Cu. In other embodiments, the second metal comprises Ag. By "majority amount", it is generally meant that the second metal is the primary component of the busbar **50**, such that it is present in an amount greater than any other component that may also be present in the busbar **50**. In certain embodiments, such a majority amount of the second metal, e.g. Cu, is generally greater than about 25, greater than about 30, greater than about 35, or greater than about 40, wt%, each based on the total weight of the busbar **50**.

The busbar **50** also generally comprises a third metal. The third metal is different from the first metal of the fingers **44**. The third metal is also different from the second metal of the busbar **50**. Typically, the metals are different elements, rather than just different oxidation states of the same metal. The "third" is used to differentiate the metal of the busbar **50** from the "first" metal of the fingers **44**, and does not imply quantity or order. The third metal melts at a lower temperature than melting temperatures of the first and second metals. Typically, the third metal has a melting temperature of no greater than about 300, no greater than about 275, or no greater than about 250, °C. Such temperatures are useful for forming the busbar **50** at low temperatures as described further below.

In certain embodiments, the third metal comprises solder, which may be the same or different from the solder of the composition **20"**. The solder can comprise various metals or alloys thereof. One of these metals is typically Sn, lead, bismuth, cadmium, zinc, gallium, indium, tellurium, mercury, thallium, antimony, selenium and/or an alloy of two or more of these metals. The third metal can be present in the busbar **50** in various amounts, typically in an amount less than the second metal. The busbar **50** typically comprises a polymer(s) in addition to the second and third metals, as described further below, which may be the same or different than the polymers of the composition **20"**.

As best shown in Figure 10, the upper doped region **36** of the base substrate **34** is free of (direct) physical contact with the busbar **50**. Specifically, the passivation layer **42** serves as a "barrier" between the busbar **50** and upper doped region **36**. Without being bound or limited by any particular theory, it is believed that physical separation of the busbar **50** and the upper doped region **36** is beneficial for at least two reasons. First, such separation prevents diffusion of the second metal, e.g. Cu, into the base substrate **34**. It is believed that preventing such diffusion prevents the opposite doped region from being shunted by the second metal of the busbar **50**. Second, such physical separation is believed to reduce minority carrier recombination at the metal and silicon interfaces. It is believed that by reducing the area of metal/silicon interface, loss due to recombination is generally reduced and open-circuit voltage (V_{OC}) and short-circuit current density (J_{SC}) are generally improved. The area is reduced due to the passivation layer **42** being disposed between much of the busbar **50** and the upper doped region **36**, with the fingers **44** being the only metal components in contact with the upper doped region **36** of the base substrate **34**. Additional embodiments of the PV cell **32** will now be described immediately below.

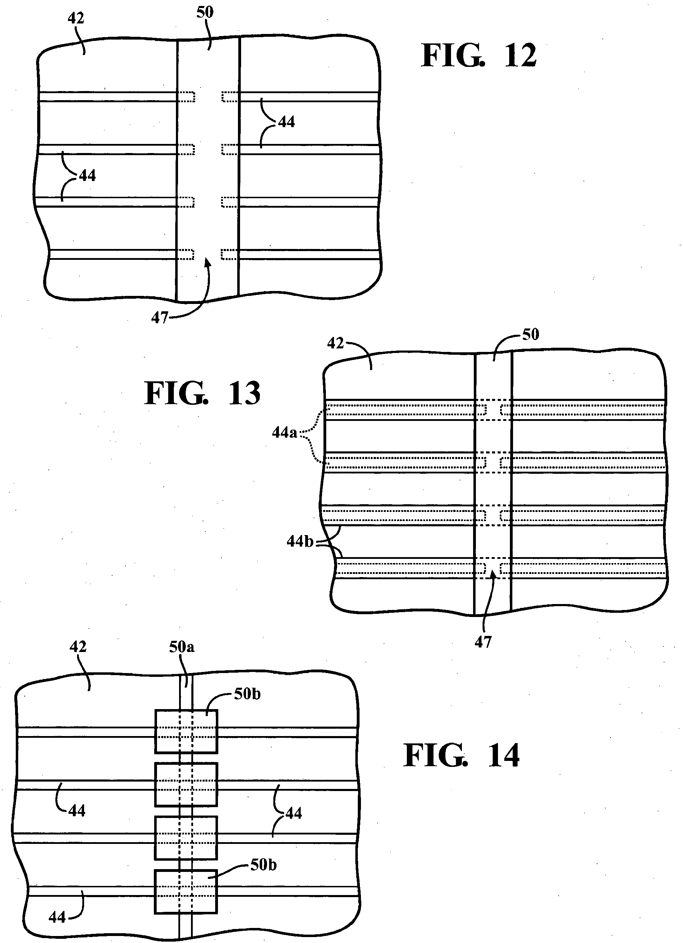

The PV cell **32** of Figure 12 is similar to that of Figure 3A, but includes discontinuous-fingers **44**. The busbar **50** is disposed over a gap **47** defined between the fingers **44**. The gap **47** can be of various widths, provided the busbar **50** is in electrical contact with the fingers **44**. The fingers **44** may comprise a majority of one metal, e.g. Ag, whereas the busbar 50 another metal, e.g. Cu (as like described above). By having gaps **47**, cost of manufacture can be reduced (such as by reducing the total amount of Ag utilized), and/or adhesion may be positively impacted.

The PV cell **32** of Figure 13 is similar to that of Figure 12, but further includes supplemental fingers **44b** disposed over the fingers **44a**. The supplemental fingers **44b** may comprise the same material as the busbar **50**, e.g. Cu, or a different material. The supplemental fingers **44b** and the busbar **50** may be separate (e.g. one lying over the other) or unitary. By utilizing the supplemental fingers **44b**, the size of the fingers **44a** (e.g. Ag fingers) can be reduced, which can reduce cost of manufacture and/or improve adhesion.

The PV cell **32** of Figure 14 includes fingers **44**, busbar **50a**, and supplemental busbar pads **50b** disposed over the fingers **44** and busbar **50a**. The fingers **44** and busbar **50** may be separate or unitary. The fingers **44** and busbar **50a** may comprise the same majority metal, e.g. Ag, or be different than each other. The busbar pads **50b** can comprise Cu or another metal, e.g. when formed from the invention composition. By utilizing the busbar pads **50b**, the size of the busbar **50a** (e.g. Ag busbar **50a**) can be reduced.

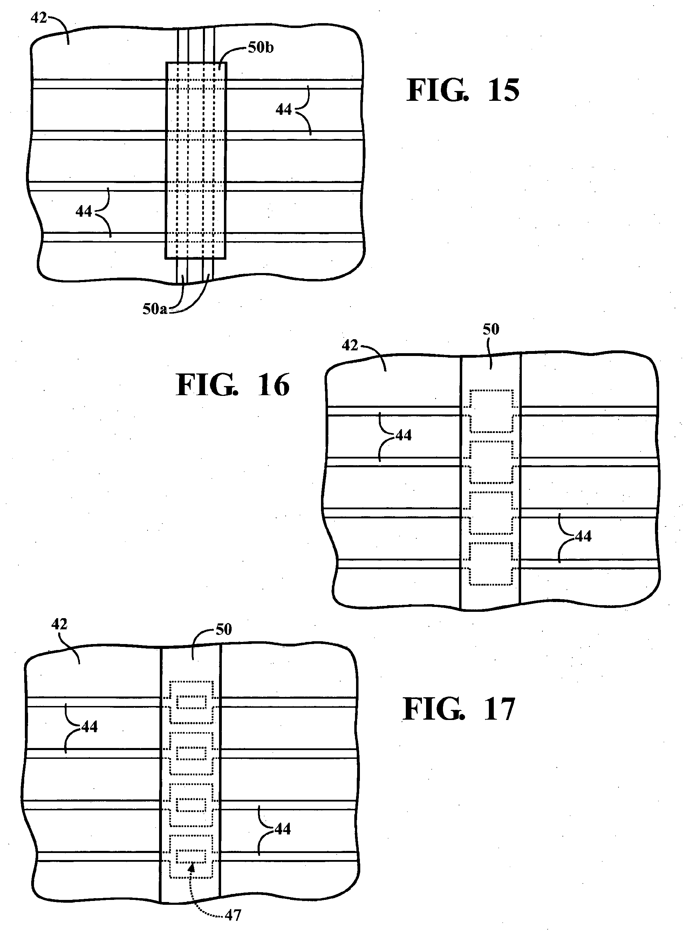

The PV cell **32** of Figure 15 is similar to that of Figures 12 and 14, but includes a pair of busbars **50a** and a supplemental busbar **50b** disposed over the busbars **50a**. The fingers **44** and busbars **50a** can be separate or unitary. The fingers **44** and busbar **50a** may comprise the same majority metal, e.g. Ag, or be different than each other. The supplemental busbar **50b** can comprise Cu or another metal. By utilizing the supplemental busbar **50b**, the size of the busbars **50a** can be reduced.

The PV cells **32** of Figures 16 and 17 are similar to that of Figure 12, but include fingers **44** having pads in place of the gaps **47**. The padded fingers **44** can help to improve electrical contact to the busbar **50**, and adhesion, while reducing the amount of Ag used and reducing manufacturing cost. The fingers **44** of Figure 17 have hollow pads, i.e., internal gaps **47**, which can reduce cost of manufacture and positively impact adhesion. A portion of the busbar **50** may be disposed in the gaps **47** of the hollow padded fingers **44**.

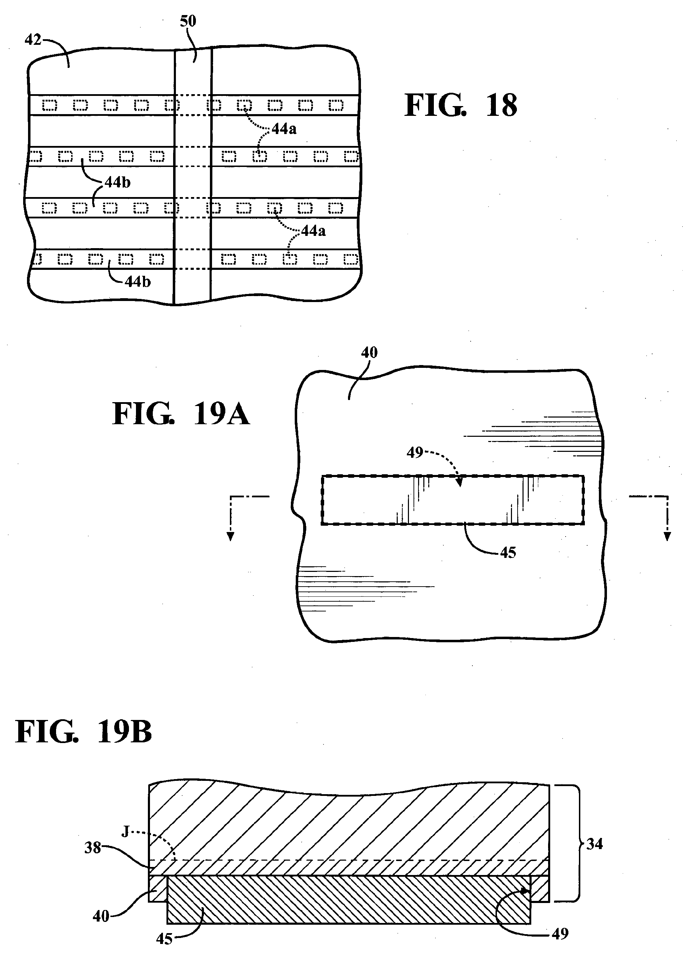

The PV cell **32** of Figure 18 is similar to that of Figure 12, but includes discontinuous-fingers **44a** with supplemental fingers **44b** disposed thereon. The discontinuous-fingers **44a** can be in various shapes, such as rectangles, squares, dots, or combinations thereof. Such fingers **44a** can be plated, printed, or formed in another manner. A plurality of gaps **47** are defined by the discontinuous-fingers **44a**. The supplemental fingers **44b** and the busbar **50** may be separate or unitary. By utilizing the discontinuous-fingers **44a** and supplemental fingers **44b**, cost of manufacture can be reduced. The discontinuous-fingers **44a** typically contact the emitter **26** while the supplemental fingers **44b** and busbar **50** carry current.

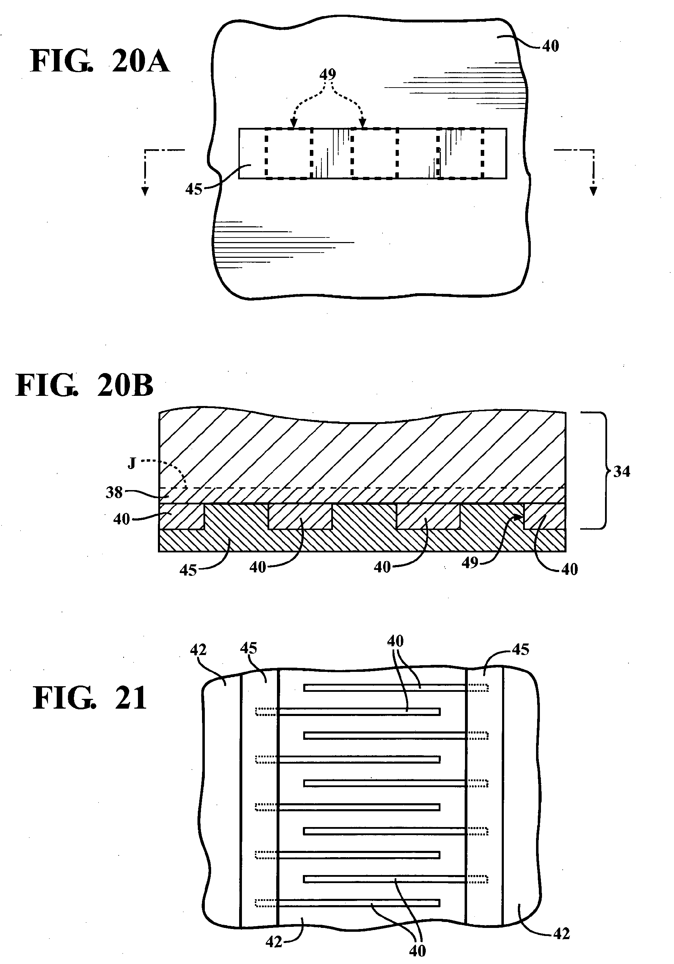

The PV cells **32** of Figure 19 and 20 are similar to that of Figure 3B. In Figure 19, the first electrode **40** defines a hole **49**, whereas in Figure 20, the first electrode **40** defines a plurality of holes **49**. The hole(s) **49** is/are also defined by the passivation layer **42**, if present. The second electrode **45** is disposed over the first electrode **40** and is in electrical contact with the base substrate **34** via the hole(s) **49**. The base substrate **34** may or may not include doping **38** proximal the hole(s) **49**. The base substrate **34** can be in direct contact with the second electrode **45**. When the second electrode **45** is formed from the composition **20"**, the solder **24** can prevent the possibility of the metal powder **26**, e.g. Cu, leaching/migrating into the base substrate **34**, e.g. Si. By utilizing the holes **49**, cost of manufacture can be reduced. Alternatively, a dielectric passivation layer **42** may be between the Cu electrode **45** and the substrate **34**. A possible benefit of a passivation layer **42** is an improved reduction in charge recombination resulting in improved cell **32** efficiency.

The PV cell **32** of Figure 21 is of an interdigitated back contact (IBC) configuration, with interdigitated fingers **40**, and a pair of busbars **45**. The busbars **45** can be formed from the composition **20"**, whereas the fingers **40** can be formed from another material, e.g. Ag. Such IBC configurations are understood in the art. The composition **20** is not limited to any particular type of configuration as described above.

The present invention also provides a method of forming the PV cell **32**. The method includes the step of applying the composition **20"** to the upper portions **48** of the fingers **44** to form a layer **50"**. The composition can be applied by various methods, as alluded to above. In certain embodiments, the composition is printed on at least a portion of the upper portions **48** of the fingers **44** to form a layer **50"**. Various types of deposition methods can be utilized, such as printing through screen or stencil, or other methods such as aerosol, ink jet, gravure, or flexographic, printing. In certain embodiments, the composition is screen printed directly onto portions of the passivation layer **42** and the upper portions **48** of the fingers **44**.

After application of the composition **20"**, the upper doped region **36** of the base substrate **34** is typically free of (direct) physical contact with the layer **50"**. The composition **20"** can be applied to the passivation layer **42** and around each of the fingers **44** to make direct physical and electrical contact to the upper portions **48** of the fingers **44** with the layer **50"**.

The method further comprises the step of heating the layer **50"** to a temperature of no greater than about 300 °C to form the busbar **50** (i.e., the conductor **20**). The layer **50"** is generally heated to a temperature of from about 150 to about 300, about 175 to about 275, about 200 to about 250, or about 225, °C. In certain embodiments, the layer **50"** is heated at about 250 °C or less to form the busbar **50**. Such temperatures generally sinter the third metal (i.e., solder powder) in the layer **50"**, but do not sinter the second metal (e.g. the metal powder) in the layer **50"** to form the busbar **50**. Such heating may also be referred to in the art as reflow or sintering.

The layer **50"** can be heated for various amounts of time to form the busbar **50**. Typically, the layer **50"** is heated only for the period of time required for the busbar **50** to form. Such times can be determined via routine experimentation. An inert gas, e.g. a N₂ gas blanket, can be used to prevent premature oxidation of the Cu **26** prior to being coated with the solder **24"**. Unnecessarily overheating the busbar **50** for longer periods of time may damage the upper doped region **36** or other components of the PV cell **32** including the busbar **50**. The same type of method can be utilized to form the second electrode **45** on the first electrode **40** using the invention composition. This can be alternate to, or in addition to, forming the busbars **50** with the invention composition **20"** as described above.

In one embodiment, prior to forming the busbar **50**, the method comprises the step of applying a coating composition to the upper doped region **36** of the base substrate **34** to form the passivation layer **42**. The coating composition can comprise various components, such as those suitable for forming the passivation layers **42** described above. The coating composition can be applied by various methods, as introduced above. For example, a PECVD process can be utilized. In embodiments where the passivation layer **42** comprises SiN_{X}, silane, ammonia, and/or other precursors can be used in a PECVD furnace to form the passivation layer **42**.

The method further comprises the step of applying a metallic composition to portions of the passivation layer **42** in a finger pattern corresponding to the fingers **44** to be formed. Each of the finger patterns generally has their lower portion in contact with the passivation layer **42** and their upper portion spaced from the passivation layer **42** after application. The metallic composition can be applied by various methods, as alluded to above. In certain embodiments, the metallic composition is printed on portions of the passivation layer **42** to form the finger patterns. Various types of printing methods can be utilized, such as screen, stencil, aerosol, ink jet, gravure, or flexographic, printing. In certain embodiments, the metallic composition is screen printed directly onto the passivation layer **42** to form the finger patterns. In other embodiments, the metallic composition is electrochemically deposited on portions of the passivation layer **42** to form the finger patterns. Other suitable methods are described above.

The metallic composition comprises the first metal present in the metallic composition in a majority amount. Such amounts are as described above. Typically, the first metal is Ag. The metallic composition typically includes one or more components for etching into the passivation layer **42**. Such components generally include fritted leaded glass. Other components may also be used in addition or alternate to leaded glass, such as unleaded or low leaded glass.

Various types of fritted or unfritted Ag of Al pastes can be used as the metallic composition. Such pastes generally include an organic carrier. Upon high temperature processing or "firing", the organic carrier burns out and is removed from the bulk composition. Ag particles are dispersed throughout the carrier. A solvent may be included to adjust rheology of the paste. The fritted paste includes glass frits, which generally comprises PbO, B₂O₃, and SiO₂. The method is not limited to any particular fritted Ag paste, provided the paste can etch through the cover sheet at elevated temperatures, as described below. Examples of suitable fritted Ag pastes are commercially available from Ferro of Mayfield Heights, OH and Heraeus Materials Technology, LLC of West Conshohocken, PA.

The method further comprises the step of heating the finger patterns to form the fingers **44**. The finger patterns are generally heated to a temperature of from about 250 to about 1000, from about 500 to about 900, or about 720, °C. Such temperatures generally sinter the first metal in the finger patterns to form the fingers **44**. This heating step is generally much higher in temperature relative to the heating step used to form the busbar **50** (i.e., conductor **20**). In addition, the glass frit allows for the finger patterns to etch through the passivation layer **42** and upon cooling, phase separate. This allows for direct electrical contact of the fingers **44** to the upper doped region **36** of the base substrate **34**. Such heating may also be referred to in the art as firing.

The finger patterns can be heated for various amounts of time to etch through the passivation layer **42**. Typically, the finger patterns are heated only for the period of time required for the fingers **44** to uniformly contact the upper doped region **36**. Such times can be determined via routine experimentation. Unnecessarily overheating the fingers **44** for longer periods of time may damage the upper doped region **36** or other components of the PV cell **32**. After heating the finger patterns such that they can etch through the passivation layer **42**, the method further comprises the step of applying a composition to at least a portion of the upper portions **48** of the fingers **44** to form the layer **50"** as described above.

In another embodiment, the fingers **44** are formed in a different manner than as described in the embodiment above. The passivation layer **42** can be formed as described above. After forming the passivation layer **42**, holes are formed therein. The holes can be formed by various methods, such as by laser ablation, chemical etching, physical etching, etc. Such etching is different from the finger **36** "etching" described above. The fingers **44** are then formed in the holes. These fingers **44** are generally the plated fingers **44** as described above. The fingers **44** can be formed by depositing various metals into the holes. Various processes can be used, and different processes can be used for each layer of the fingers **44**. An electrochemical plating process may be used to form the layers in the holes. Typically, such processes do not require a separate heating/firing step as described above. After forming the fingers **44**, the method further comprises the step of applying a composition to at least a portion of the upper portions **48** of the fingers **44** to form the layer **50"** as described above.

As like the conductor **20**, the busbar **50** is directly solderable, which is useful for tabbing multiple PV cells **32** together, such as by attaching ribbons or interconnects to the busbars **50** of the PV cells **32**. By using the busbar **50** and tabbing, it is possible to collect current from the fingers **44** effectively. As introduced above, the PV cell **32** may be used in various applications.

Referring to Figure 11, tabbing **52** is disposed on the busbars **50**. In certain embodiments, the tabbing **52** is directly solderable to the busbars **50** of the PV cells **32**. In other embodiments, additional solder (not shown) may be used between the busbars **50** and tabbing **52**. Fluxing means may be used to aid in soldering, such a flux pen or flux bed. The tabbing **52** itself may also include flux, such as Sn or Sn alloys and flux. The tabbing **52** can be formed from various materials, such as Cu, Sn, etc. Such tabbing **52** can be used to connect a series of PV cells **32**. For example, a PV cell module (not shown) can include a plurality of the PV cells **32**. Tabbing **52**, e.g. ribbon, is generally in physical contact with the busbars **50** of the PV cells **32** to electrically connect the PV cells **32** in series. The tabbing **52** may also be referred to in the art as an interconnection. The PV module may also include other components, such as tie layers, substrates, superstrates, and/or additional materials that provide strength and stability. In many applications, the PV cells **32** are encapsulated to provide additional protection from environmental factors such as wind and rain.

The following examples, illustrating the composition **20"** and conductors **20** of the present invention are intended to illustrate and not to limit the invention. The amount and type of each component used to form the compositions is indicated in Tables 1 through 3 below with all values in wt% based on a total weight of the respective composition unless otherwise indicated.

**Table 1**

| **Component (wt%)** | **Example** | | |
|---|---|---|---|
| | **0** | **1** | **2** |
| Polymer | 1.7601 | 1.7325 | 1.7243 |
| Additive 1 | 2.0467 | 2.0145 | 2.0050 |
| Additive 2 | 0.2865 | 0.2820 | 0.2807 |
| Carboxylated-Polymer | 3.7208 | 3.6627 | 3.6362 |
| Dicarboxylic Acid | 0.2489 | 0.4875 | 0.2432 |
| Monocarboxylic Acid | 0.4953 | 0.2450 | 0.4840 |
| Additive 3 | 1.8608 | 1.8317 | 1.8185 |
| Additive 4 | 1.8608 | 1.8317 | 1.8185 |
| Metal Powder | 47.7200 | 46.9642 | 46.5600 |
| Solder Powder 1 | 15.6250 | 15.6520 | 16.2283 |
| Solder Powder 2 | 24.3750 | 23.8343 | 23.7501 |
| Additive 5 | - | 0.2931 | 0.5567 |
| Additive 6 | - | 0.1016 | - |
| Additive 7 | - | 0.1718 | - |
| Additive 8 | - | 0.2715 | 0.3036 |
| Additive 9 | - | 0.6239 | 0.5907 |
| **Total** | **100.00** | **100.00** | **100.00** |

Polymer is a solid epoxy resin comprising the reaction product of epichlorohydrin and bisphenol A and having an EEW of 500-560 g/eq, commercially available from Dow Chemical.
Additive 1 is a monoterpene alcohol, commercially available from Sigma Aldrich.
Additive 2 is a styrene dibromide, commercially available from Sigma Aldrich.
Carboxylated-Polymer is a low molecular weight styrene-acrylic copolymer having an acid value of about 238 (on solids), commercially available from BASF Corp.
Dicarboxylic Acid is commercially available from Sigma Aldrich.
Monocarboxylic Acid is commercially available from Hexion Specialty Chemicals.
Additive 3 is a propylene glycol, commercially available from Sigma Aldrich.
Additive 4 is a benzyl alcohol, commercially available from Sigma Aldrich.
Metal Powder is copper powder, commercially available from Mitsui Mining & Smelting Co.
Solder Powder 1 is a Sn42/Bi58 alloy, having a melting temperature of about 138 °C, commercially available from Indium Corporation of America.
Solder Powder 2 is a Sn96.5/Ag3.5 alloy, having a melting temperature of about 221 °C, commercially available from Indium Corporation of America.

Additive 5 is a titanate adhesion promoter, commercially available from Kenrich Petrochemicals Co.
Additive 6 is a copper deactivator comprising oxalyl bis(benzylidenehydrazide), commercially available from Eastman Chemical Co.
Additive 7 is a silicone-free defoamer, commercially available from BYK additives & instruments.
Additive 8 is a silane adhesion promoter comprising 2-(3,4-epoxycyclohexyl) ethyltrimethoxysilane, commercially available from Dow Corning Corp.
Additive 9 is a butyl carbitol, commercially available from Dow Chemical.

**Table 2**

| **Component (wt%)** | **Example** | | |
|---|---|---|---|
| | **3** | **4** | **5** |
| Polymer | 1.7051 | 1.6997 | 1.7467 |
| Additive 1 | 1.9827 | 1.9765 | 2.0311 |
| Additive 2 | 0.2776 | 0.2767 | 0.2844 |
| Carboxylated-Polymer | 3.6036 | 3.5941 | 3.6952 |
| Dicarboxylic Acid | 0.2410 | 0.2404 | 0.2472 |
| Monocarboxylic Acid | 0.4797 | 0.4784 | 0.4919 |
| Additive 3 | 1.8022 | 1.7974 | 1.8480 |
| Additive 4 | 1.8022 | 1.7974 | 1.8480 |
| Metal Powder | 46.1663 | 46.0697 | 57.8686 |
| Solder Powder 1 | 17.2656 | 17.3370 | 16.1390 |
| Solder Powder 2 | 23.4148 | 23.3854 | 12.8472 |
| Additive 5 | - | - | 0.3184 |
| Additive 6 | 0.3258 | - | 0.1570 |
| Additive 7 | - | 0.3084 | 0.1259 |
| Additive 8 | 0.2581 | 0.3498 | 0.2681 |
| Additive 9 | 0.6752 | 0.6891 | 0.0834 |
| **Total** | **100.00** | **100.00** | **100.00** |

**Table 3**

| **Component (wt%)** | **Example** | | | |
|---|---|---|---|---|
| | **6** | **7** | **8** | **9** |
| Polymer | 1.7451 | 1.7873 | 4.9492 | 4.9664 |
| Additive 1 | 2.0241 | 1.5386 | 4.2386 | 4.2533 |
| Additive 2 | 0.3049 | 0.3021 | 0.6893 | 0.6917 |
| Carboxylated-Polymer | - | 5.1469 | 2.4731 | 2.4430 |
| Dicarboxylic Acid | - | - | 1.9982 | 1.9738 |
| Monocarboxylic Acid | - | - | - | - |
| Additive 3 | 1.8593 | - | 2.4778 | 2.4476 |
| Additive 4 | 1.8849 | 5.4753 | - | - |
| Metal Powder | 47.2075 | 56.4608 | 29.7952 | 39.3662 |
| Solder Powder 1 | 15.4282 | 14.0947 | 10.8638 | 13.6477 |
| Solder Powder 2 | 24.0367 | 14.3246 | 31.8660 | 29.4230 |
| Silver Powder 1 | - | - | 9.8041 | - |
| Dimer Acid | 4.4656 | - | - | - |
| Additive 5 | 0.4775 | 0.3589 | 0.5798 | 0.5230 |
| Additive 6 | 0.1817 | 0.1157 | - | - |
| Additive 7 | 0.1288 | 0.1370 | 0.2647 | 0.2642 |
| Additive 8 | 0.1111 | 0.1440 | - | - |
| Additive 9 | - | - | - | - |
| Additive 10 | 0.1446 | 0.1142 | - | - |
| **Total** | **100.00** | **100.00** | **100.00** | **100.00** |

Silver powder is a conventional silver flake from Ferro.
Dimer Acid is a distilled dimerized fatty acid with low monomer content and trimer content, commercially available from Arizona Chemical of Jacksonville, FL.
Additive 10 is 2-(3,4-epoxycyclohexyl) ethyltrimethoxysilane.

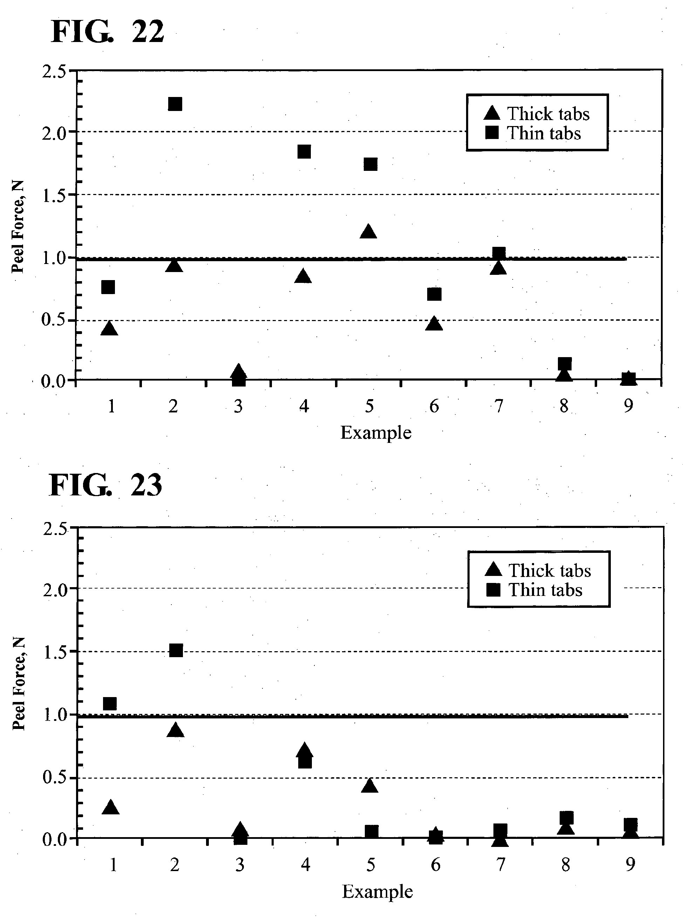

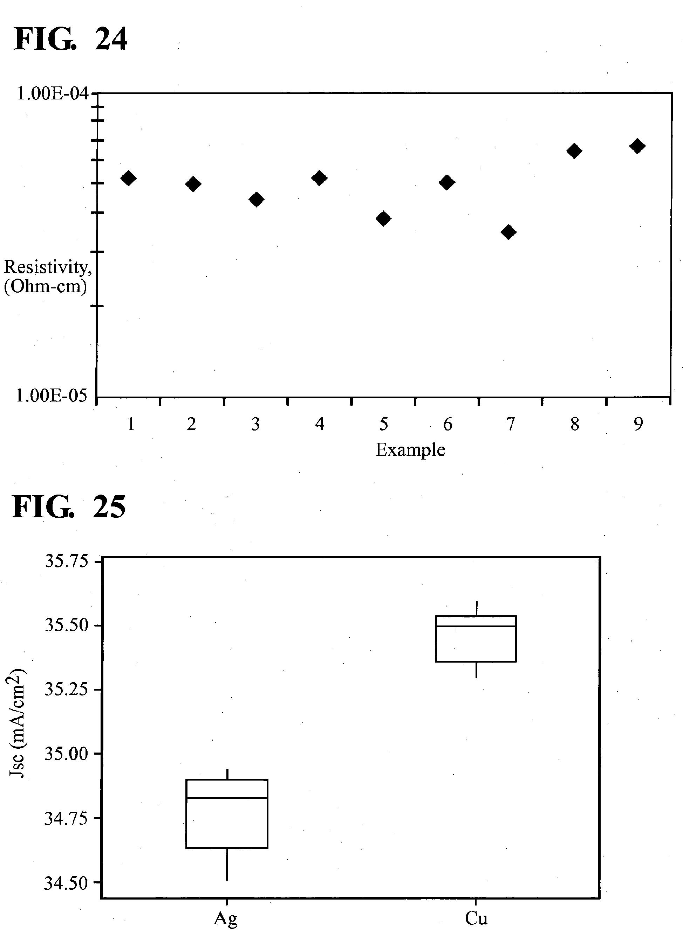

Referring to Figures 22 and 23, data from 90 degree peel testing illustrates paste adherence to different substrates and paste capability to connect to external wiring through soldering. Referring to Figure 24, paste bulk resistance dependence on the difference in composition is illustrated. It is evident that the resistivity of all nine pastes which slightly differ in composition and main components ratios remains relatively unaffected and is in the range of 3 to 6x10⁻⁵ Ω.cm. Example numbers of Tables 1 through 3 correspond to those numbers in Figures 22 through 24, i.e. Examples 1 through 9.

A series of 5 inch (12.7 cm) monocrystalline silicon cells (wafers) are prepared for application of Ag and Cu pastes. Cu paste based on Example 0 in Table 1 above is prepared The Cu paste is diluted down with 1 wt% butyl carbitol to improve print rheology. The Cu paste is printed on the wafers to form Cu busbars via a busbar screen from Sefar, a stainless steel screen 325 or 165 mesh, with a 12.7 µm emulsion thickness (PEF2), and a 22° or 45° rotation of the mesh. Printing is performed with an AMI screen printer with a ~0.68 kg down force, with a 200 µm blank wafer on the stage. Print speed is set to between 3 to 5 inch/sec in a print-print mode. The wafers are printed and put through a BTU Pyramax N₂ reflow oven.

Durability of the Cu busbars under damp heat (DH; 85 °C, 85% relative humidity) aging conditions is determined. Unencapsulated prints of Cu busbars on silicon are used to monitor the Cu bulk resistivity (p). The quality of the tabbing/Cu busbars is also monitored using contact resistivity (ρ_{C}) utilizing the TLM method. After 1000 hours of exposure to DH, no degradation of the Cu busbars is seen relative to the Ag busbars.

Current-voltage (I-V) measurements using a flash tester (Berger PSS 10 II) are performed. The Cu busbars show increased V_{OC} and J_{SC} compared to the comparative Ag busbars in front busbar examples. Specifically, cells including Cu busbars show a distinct improvement in V_{OC} and J_{SC}, relative to cells including Ag busbars. The increase generally corresponds to a 0.6% and 2.59% relative increase in V_{OC} and J_{SC}, respectively. It is believed that this increase is attributed to the reduction of metal/silicon contact area, as described above.

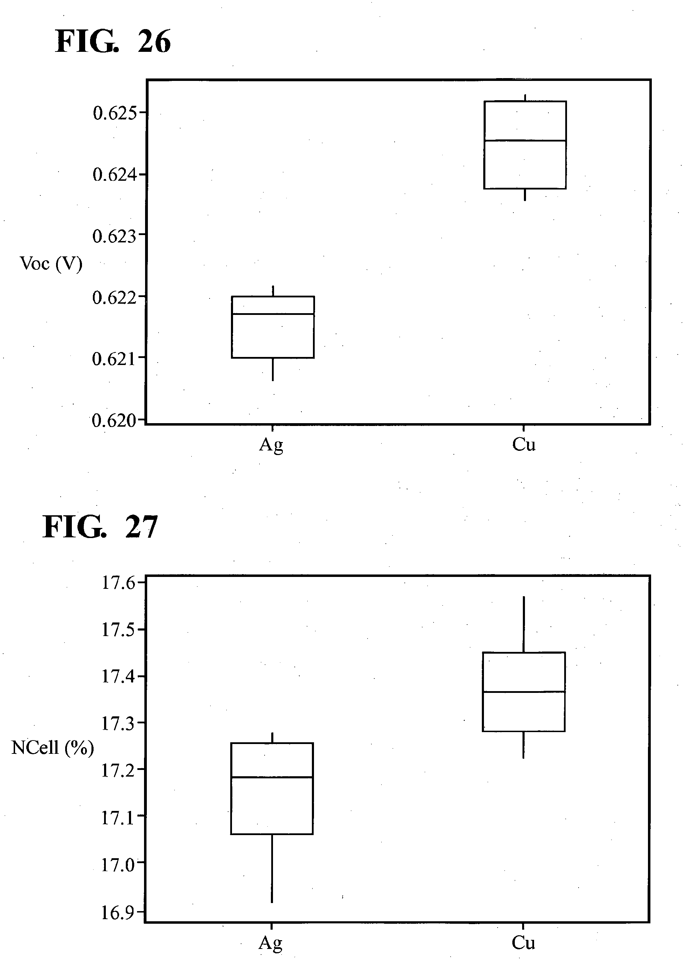

A batch of screen printed Al BSF wafers is prepared with rear contact pads. The wafers include front Ag and front Cu prints all with rear Ag busbars. The Cu busbars are printed with the Cu paste as described above. The cells are tabbed manually and tested prior to encapsulation. The cells can be tabbed using typical industry tabbing. In these examples, tabbing can be performed by hand using a soldering iron at 390°C and flux. Front grid resistance is measured, along with I-V, and Suns Voc to determine quality of the cells and the metallization. The measurement results are shown in Figures 25 through 27. The batch shows an improved V_{OC} and J_{SC}, again attributed to a decrease in metal/silicon contact area.

Another series of 5 inch (12.7 cm) monocrystalline silicon cells (wafers) are prepared for application of additional Ag and Cu pastes. Example 0 in Table 1 above is repeated for testing of additional Cu electrodes. The cells all include standard Ag front grids (fingers and busbars), and a rear layer of Al (first electrode). Cu electrodes (second electrodes) are printed directly on top of the Al first electrode. Comparative examples with openings in the rear layer of Al (first electrode) with Ag/Al busbars printed on the openings to form second electrodes are indicated in the Figures by "Ag". Example 0 is indicated by "Cu R" or simply "Cu" in the Figures. All cells are from the same batch (i.e., identically processed up to rear side metallization using either the Ag or the Cu). The cells are tabbed through manual soldering.

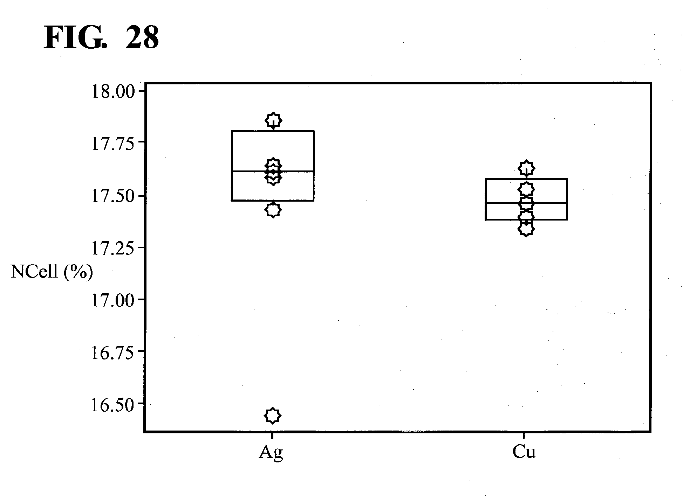

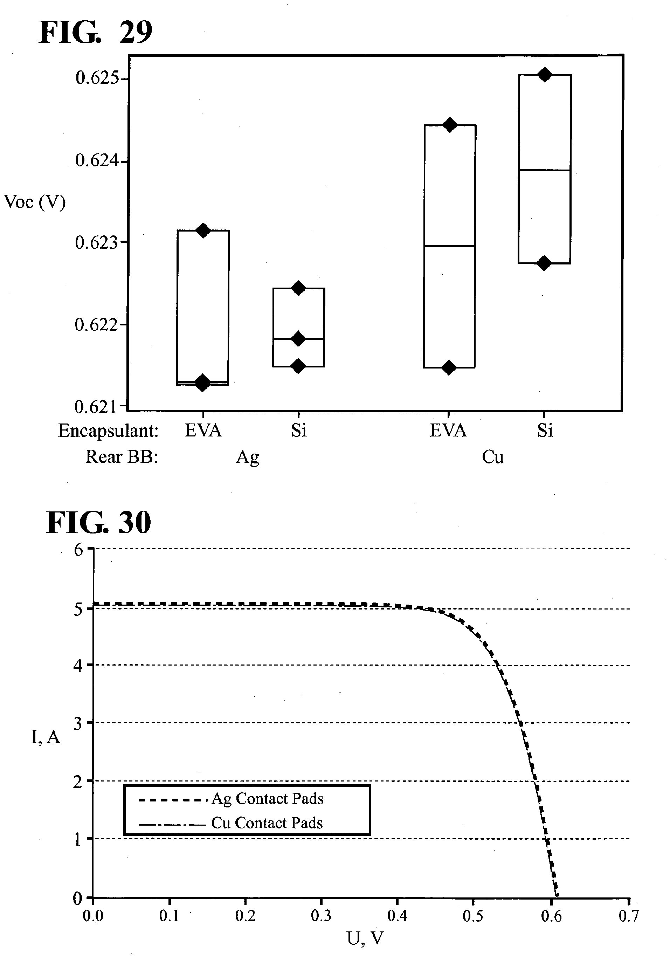

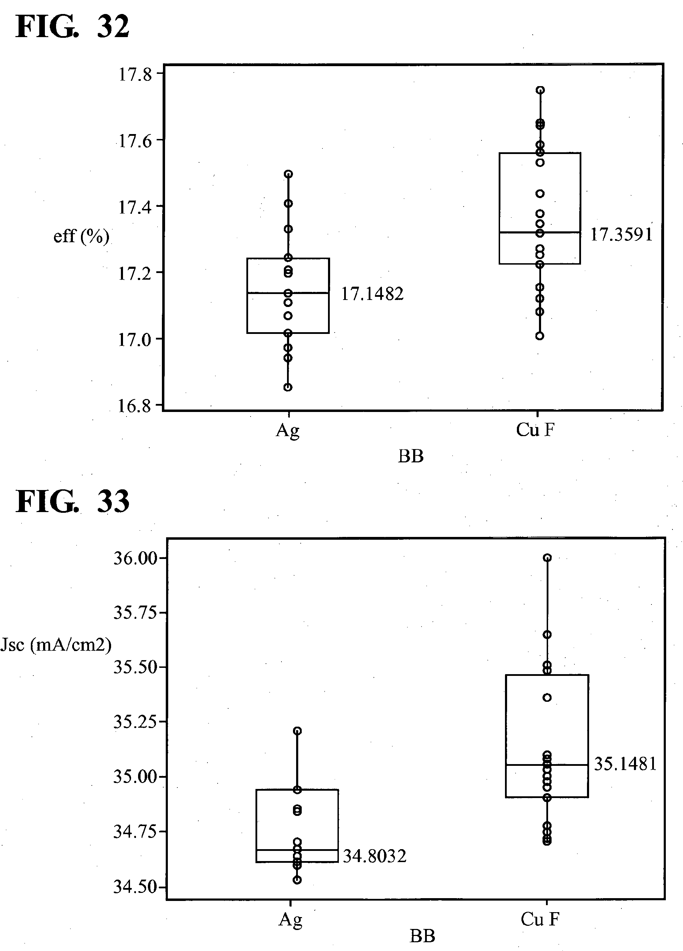

Current-voltage (I-V) measurements using a flash tester (PSS 10 II) are performed. Referring to Figure 28, I-V data for rear Cu busbar Example 0 compared to Ag busbar examples, as second electrodes, is illustrated. The examples both have front Ag busbars, and are configured as i-PERC cells. Referring to Figure 29, I-V results for Al BSF cells with Cu busbar Example 0 printed on the rear or Ag controls are illustrated. Cells are encapsulated into mini-modules using either EVA or silicone polymers (denoted as Si). Efficiency is comparable and V_{OC} shows an improvement. Figure 30 illustrates I-V characteristics of a comparative cell having Ag contacts on Al and an invention cell having Cu contacts, per Example 0, on Al. As shown in Figure 33, the Cu contact pads do not have a negative impact on cell performance.

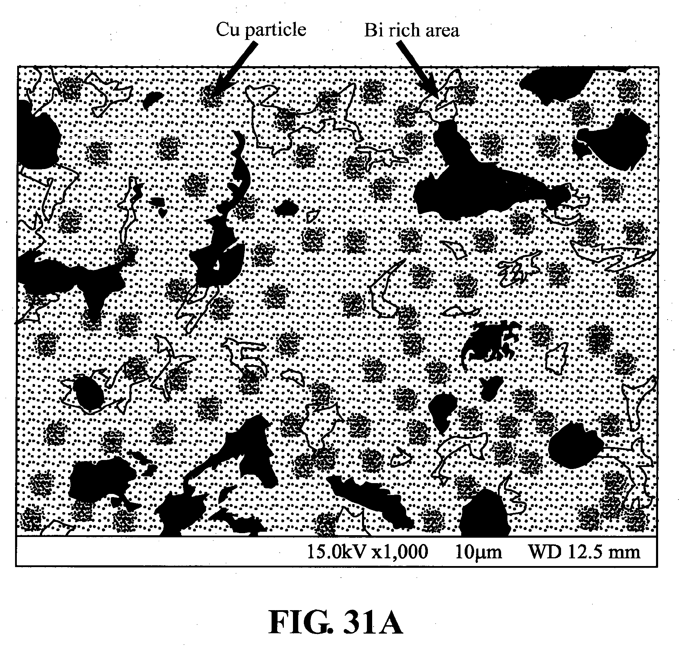

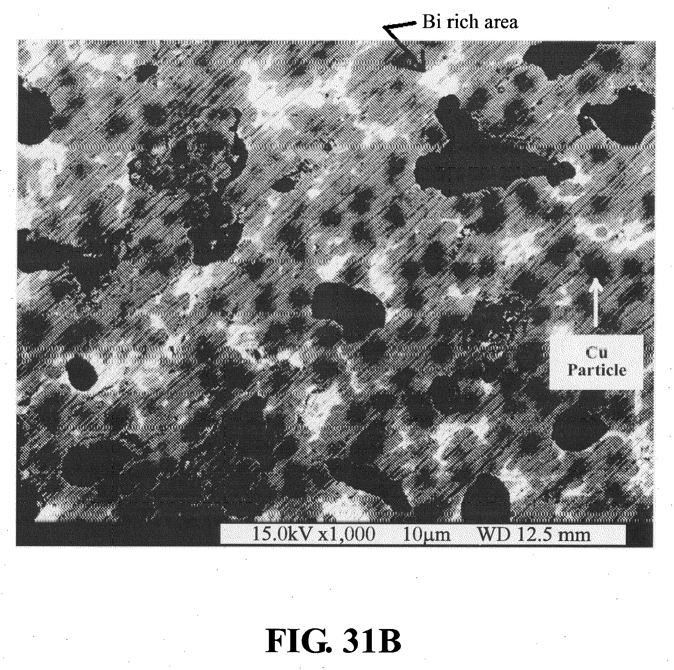

Referring to Figure 31, a cross-sectional SEM micrograph of Example 0 is depicted. Dark grey generally indicates Cu, medium grey generally indicates Sn, white regions generally indicates Bi rich Sn areas, and black areas generally indicate voids and/or epoxy/acrylic binder.

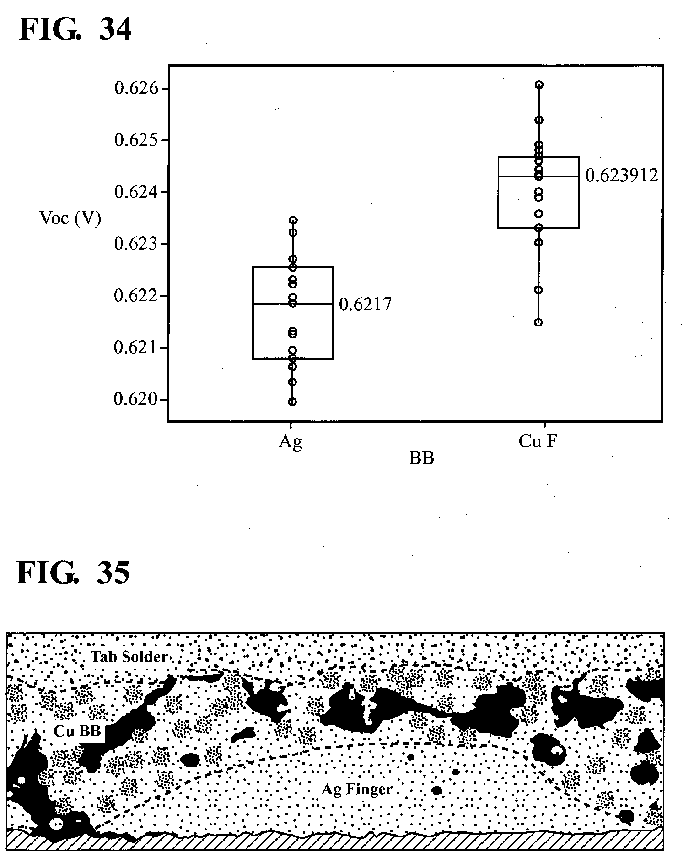

Referring to Figure 32, a box graph illustrating efficiency percentage of the comparative and invention PV cells is depicted, whereas Figure 33 illustrates J_{SC}, and Figure 34 illustrates V_{OC} of the examples. Specifically, IV data for samples is measured. Ag examples are 149-1 through 15, and Cu F examples are 149-A through S. Mean values are shown. The comparative and invention examples are the same as described above in the previous example Figures. From the data, it is clearly shown that the use of the Cu busbar of the present invention has a distinct improvement in cell performance. This improvement is believed to come from the reduced recombination by reducing the metal/silicon interface area with reduced high temperature fired Ag metallization points.

Figure 35 is a cross-sectional optical microscopy photograph illustrating a tabbed busbar of the invention. Specifically, a Cu busbar is printed on top of a SiNx passivation layer and on top a Ag finger and later tabbed. Various components of the invention composition are shown in the cross-section. A direct solder bond to the tabbing/busbar and busbar/finger is shown, as well as the adhesive contact between the Cu busbar and the substrate.

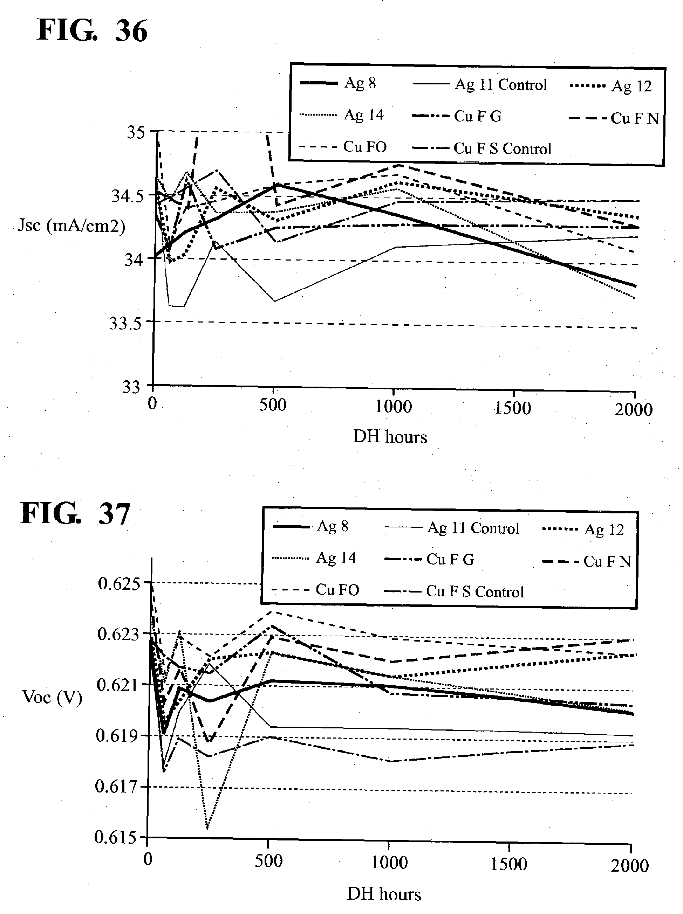

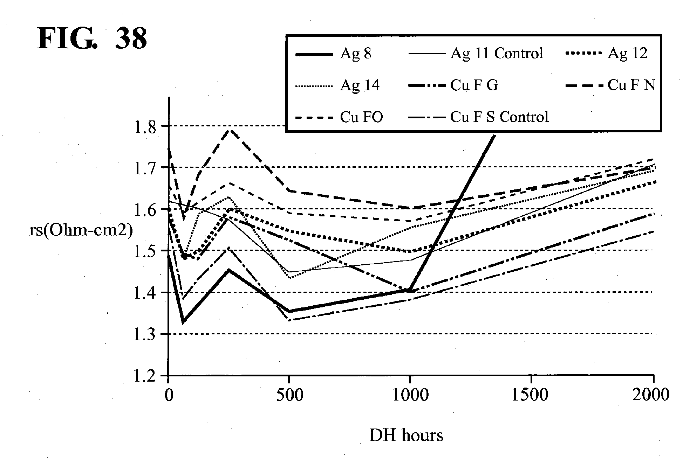

Figure 36 is a line graph illustrating J_{SC} of comparative and invention PV cell examples after damp heat aging. Figure 37 is a line graph illustrating V_{OC} of the comparative and invention PV cells after damp heat aging, and Figure 38 is a line graph illustrating sheet resistivity (rs) of the comparative and invention PV cell examples after damp heat aging. From these graphs it is clear that the Cu paste is not degrading performance under corrosive conditions.

One or more of the values described above may vary by ±5%, ±10%, ±15%, ±20%, ±25%, etc. so long as the variance remains within the scope of the disclosure. Unexpected results may be obtained from each member of a Markush group independent from all other members. Each member may be relied upon individually and or in combination and provides adequate support for specific embodiments within the scope of the appended claims. The subject matter of all combinations of independent and dependent claims, both singly and multiply dependent, is herein expressly contemplated. The disclosure is illustrative including words of description rather than of limitation. Many modifications and variations of the present disclosure are possible in light of the above teachings, and the disclosure may be practiced otherwise than as specifically described herein.

## Claims

1. A composition comprising:
a metal powder;
a solder powder which has a lower melting temperature than a melting temperature of said metal powder;
a polymer which comprises epoxy resin;
a carboxylated-polymer different from said polymer for fluxing said metal powder and cross-linking said polymer;
a dicarboxylic acid for fluxing said metal powder; and
a monocarboxylic acid for fluxing said metal powder; and
an adhesion promoter or defoamer,
wherein the ratio of acidic groups to epoxy groups is at least 3:1.

2. The composition as set forth in claim 1, wherein said metal powder comprises copper.

3. The composition as set forth in any one of the preceding claims, wherein said solder powder has a melting temperature of no greater than 300 °C.

4. The composition as set forth in any one of the preceding claims, wherein said solder powder comprises at least one tin (Sn) alloy and no greater than 0.5 weight percent (wt%) of:
i) mercury, cadmium, and/or chromium; and/or
ii) lead.

5. The composition as set forth in any one of the preceding claims, wherein:
i) said polymer comprises an epoxy resin; and/or
ii) said carboxylated-polymer comprises an acrylic polymer.

6. The composition as set forth in any one of the preceding claims, wherein said:
i) carboxylated-polymer comprises a styrene-acrylic copolymer; and/or
ii) solder powder comprises at least one of a tin-bismuth (SnBi) alloy, a tin-silver (SnAg) alloy, or combinations thereof; and/or
iii) dicarboxylic acid is dodecanedioic acid (DDDA); and/or
iv) monocarboxylic acid is neodecanoic acid.

7. The composition as set forth in any one of the preceding claims, further comprising:
i) an additive comprising a solvent;
ii) an adhesion promoter comprising a silane, a titanate, or combinations thereof; or
iii) both i) and ii).

8. The composition as set forth in any one of the preceding claims, wherein:
i) said metal and solder powders are collectively present in an amount of from 50 to 95 wt% based on the total weight of said composition;
ii) said metal powder is present in an amount of from 35 to 85 wt% based on the total weight of said composition; and/or
iii) said solder powder is present in any amount of from 25 to 75 wt% based on the total weight of said composition.

9. The composition as set forth in any one of the preceding claims, wherein:
i) said polymer and said carboxylated-polymer are collectively present in an amount of from 2.5 to 10 wt% based on the total weight of said composition;
ii) said polymer is present in an amount of from 0.5 to 5 wt% based on the total weight of said composition; and/or
iii) said carboxylated-polymer is present in an amount of from 1 to 7.5 wt% based on the total weight of said composition.

10. The composition as set forth in any one of the preceding claims, wherein said:
i) dicarboxylic acid is present in an amount of from 0.05 to 1 wt% based on the total weight of said composition;
ii) monocarboxylic acid is present in an amount of from 0.25 to 1.25 wt% based on the total weight of said composition; or
iii) both i) and ii).

11. The composition as set forth in any one of the preceding claims, wherein said polymer and said carboxylated-polymer are in a weight ratio of from 1:1 to 1:3 (polymer:carboxylated-polymer).

12. A conductor formed from the composition as set forth in any one of the preceding claims.

13. An article comprising:
i) a substrate; and
ii) a conductor disposed on and in electrical contact with said i) substrate for current transport, said ii) conductor formed from;
a metal powder,
a solder powder which has a lower melting temperature than a melting temperature of said metal powder,
a polymer which comprises epoxy resin,
a carboxylated-polymer different from said polymer for fluxing said metal powder and cross-linking said polymer,
a dicarboxylic acid for fluxing said metal powder, and
a monocarboxylic acid for fluxing said metal powder; and
an adhesion promoter or defoamer,
wherein the ratio of acidic groups to epoxy groups is at least 3:1.

14. The article as set forth in claim 13, wherein said substrate is **characterized by** at least one of the following:
i) is conductive;
ii) comprises aluminum, silver, or a combination thereof;
iii) is a dielectric;
iv) comprises silicon;
v) comprises a solderable metal; or
vi) comprises a non-solderable metal.

15. The article as set forth in claim 13 or 14, further defined as a photovoltaic (PV) cell or a circuit board.

## Patentansprüche

1. Zusammensetzung, umfassend:
ein Metallpulver;
ein Lötpulver, das eine Schmelztemperatur aufweist, die niedriger ist als eine Schmelztemperatur des Metallpulvers;
ein Polymer, das Epoxidharz umfasst;
ein carboxyliertes Polymer, das von dem Polymer verschieden ist, zum Fluxen des Metallpulvers und zum Vernetzen des Polymers;
eine Dicarbonsäure zum Fluxen des Metallpulvers; und
eine Monocarbonsäure zum Fluxen des Metallpulvers; und
einen Haftvermittler oder Entschäumer,
wobei das Verhältnis von sauren Gruppen zu Epoxidgruppen mindestens 3:1 beträgt.

2. Zusammensetzung nach Anspruch 1, wobei das Metallpulver Kupfer umfasst.

3. Zusammensetzung nach einem der vorstehenden Ansprüche, wobei das Lötpulver eine Schmelztemperatur von nicht über 300 °C aufweist.

4. Zusammensetzung nach einem der vorstehenden Ansprüche, wobei das Lötpulver mindestens eine Zinn (Sn)-Legierung aufweist sowie nicht mehr als 0,5 Gewichtsprozent (Gew.-%) von:
i) Quecksilber, Cadmium und/oder Chrom; und/oder
ii) Blei.

5. Zusammensetzung nach einem der vorstehenden Ansprüche, wobei:
i) das Polymer ein Epoxidharz umfasst; und/oder
ii) das carboxylierte Polymer ein Acrylpolymer umfasst.

6. Zusammensetzung nach einem der vorstehenden Ansprüche, wobei:
i) das carboxylierte Polymer ein Styrol-Acryl-Copolymer umfasst; und/oder
ii) das Lötpulver eine Zinn-Wismut (SnBi)-Legierung, eine Zinn-Silber (SnAg)-Legierung und/oder Kombinationen davon umfasst; und/oder
iii) die Dicarbonsäure Dodecandisäure (DDDA) ist und/oder
iv) die Monocarbonsäure Neodecansäure ist.

7. Zusammensetzung nach einem der vorstehenden Ansprüche, ferner umfassend:
i) einen Zusatz, der ein Lösungsmittel umfasst;
ii) einen Haftvermittler, der ein Silan, ein Titanat oder Kombinationen davon umfasst; oder
iii) sowohl i) als auch ii).

8. Zusammensetzung nach einem der vorstehenden Ansprüche, wobei:
i) das Metall und das Lötpulver zusammen in einer Menge von 50 bis 95 Gew.-%, bezogen auf das Gesamtgewicht der Zusammensetzung, vorhanden sind;
ii) das Metallpulver in einer Menge von 35 bis 85 Gew.-%, bezogen auf das Gesamtgewicht der Zusammensetzung, vorhanden ist; und/oder
iii) das Lötpulver in einer beliebigen Menge von 25 bis 75 Gew.-%, bezogen auf das Gesamtgewicht der Zusammensetzung, vorhanden ist.

9. Zusammensetzung nach einem der vorstehenden Ansprüche, wobei:
i) das Polymer und das carboxylierte Polymer zusammen in einer Menge von 2,5 bis 10 Gew.-%, bezogen auf das Gesamtgewicht der Zusammensetzung, vorhanden sind;
ii) das Polymer in einer Menge von 0,5 bis 5 Gew.-%, bezogen auf das Gesamtgewicht der Zusammensetzung, vorhanden ist; und/oder
iii) das carboxylierte Polymer in einer Menge von 1 bis 7,5 Gew.-%, bezogen auf das Gesamtgewicht der Zusammensetzung, vorhanden ist.

10. Zusammensetzung nach einem der vorstehenden Ansprüche, wobei:
i) die Dicarbonsäure in einer Menge von 0,05 bis 1 Gew.-%, bezogen auf das Gesamtgewicht der Zusammensetzung, vorhanden ist;
ii) die Monocarbonsäure in einer Menge von 0,25 bis 1,25 Gew.-%, bezogen auf das Gesamtgewicht der Zusammensetzung, vorhanden ist; oder
iii) sowohl i) als auch ii) zutrifft.

11. Zusammensetzung nach einem der vorstehenden Ansprüche, wobei das Polymer und das carboxylierte Polymer ein Gewichtsverhältnis von 1:1 bis 1:3 (Polymer:carboxyliertes Polymer) aufweisen.

12. Leiter, der aus der Zusammensetzung nach einem der vorstehenden Ansprüche gebildet ist.

13. Gegenstand, umfassend:
i) eine Unterlage; und
ii) einen Leiter, der i) auf der Unterlage angeordnet ist und mit dieser in elektrischem Kontakt steht, wobei ii) der Leiter gebildet ist aus:
einem Metallpulver,
einem Lötpulver, das eine Schmelztemperatur aufweist, die niedriger ist als die Schmelztemperatur des Metallpulvers,
einem Polymer, das Epoxidharz umfasst,
einem carboxylierten Polymer, das von dem Polymer verschieden ist, zum Fluxen des Metallpulvers und zum Vernetzen des Polymers,
einer Dicarbonsäure zum Fluxen des Metallpulvers, und
einer Monocarbonsäure zum Fluxen des Metallpulvers; und
einen Haftvermittler oder Entschäumer,
wobei das Verhältnis von sauren Gruppen zu Epoxidgruppen mindestens 3:1 beträgt.

14. Gegenstand nach Anspruch 13, wobei die Unterlage **dadurch gekennzeichnet ist, dass** mindestens eines der Folgenden zutrifft:
i) sie ist leitend;
ii) sie umfasst Aluminium, Silber oder eine Kombination davon;
iii) sie ist ein Dielektrikum;
iv) sie umfasst Silicium;
v) sie umfasst ein lötbares Metall; oder
vi) sie umfasst ein nicht-lötbares Metall.

15. Gegenstand nach Anspruch 13 oder 14, der ferner als photovoltaische (PV) Zelle oder als Leiterplatte definiert ist.

## Revendications

1. Composition comprenant :
une poudre métallique ;
une poudre à braser qui a une température de fusion inférieure à une température de fusion de ladite poudre métallique ;
un polymère qui comprend une résine époxyde ;
un polymère carboxylé différent dudit polymère destiné à fluidifier ladite poudre métallique et à réticuler ledit polymère ;
un acide dicarboxylique destiné à fluidifier ladite poudre métallique ; et
un acide monocarboxylique destiné à fluidifier ladite poudre métallique ; et
un promoteur d'adhésion ou un agent anti-mousse,
le rapport des groupes acides sur les groupes époxy étant d'au moins 3:1.

2. Composition selon la revendication 1, dans laquelle ladite poudre métallique comprend du cuivre.

3. Composition selon l'une quelconque des revendications précédentes, dans laquelle ladite poudre à braser a une température de fusion non supérieure à 300 °C.

4. Composition selon l'une quelconque des revendications précédentes, dans laquelle ladite poudre à braser comprend au moins un alliage d'étain (Sn) et pas plus de 0,5 % en poids (% pds) de :
i) mercure, cadmium et/ou chrome ; et/ou
ii) plomb.

5. Composition selon l'une quelconque des revendications précédentes, dans laquelle :
i) ledit polymère comprend une résine époxy ; et/ou
ii) ledit polymère carboxylé comprend un polymère acrylique.

6. Composition selon l'une quelconque des revendications précédentes, dans laquelle :
i) ledit polymère carboxylé comprend un copolymère styrène-acrylique ; et/ou
ii) ladite poudre à braser comprend l'un au moins parmi un alliage étain-bismuth (SnBi), un alliage étain-argent (SnAg), ou des combinaisons de ceux-ci ; et/ou
iii) ledit acide dicarboxylique est l'acide dodécanedioïque (DDDA) ; et/ou
iv) ledit acide monocarboxylique est l'acide néodécanoïque.

7. Composition selon l'une quelconque des revendications précédentes, comprenant, en outre :
i) un additif comprenant un solvant ;
ii) un promoteur d'adhésion comprenant un silane, un titanate, ou des combinaisons de ceux-ci ; ou
iii) à la fois i) et ii).

8. Composition selon l'une quelconque des revendications précédentes, dans laquelle :
i) lesdites poudres métallique et à braser sont présentes collectivement en une quantité de 50 à 95 % en poids en fonction du poids total de ladite composition ;
ii) ladite poudre métallique est présente en une quantité de 35 à 85 % en poids en fonction du poids total de ladite composition ; et/ou
iii) ladite poudre à braser est présente en une quelconque quantité de 25 à 75 % en poids en fonction du poids total de ladite composition.

9. Composition selon l'une quelconque des revendications précédentes, dans laquelle :
i) lesdits polymère et polymère carboxylé sont présents collectivement en une quantité de 2,5 à 10 % en poids en fonction du poids total de ladite composition ;
ii) ledit polymère est présent en une quantité de 0,5 à 5 % en poids en fonction du poids total de ladite composition ; et/ou
iii) ledit polymère carboxylé est présent en une quantité de 1 à 7,5 % en poids en fonction du poids total de ladite composition.

10. Composition selon l'une quelconque des revendications précédentes, dans laquelle :
i) l'acide dicarboxylique est présent en une quantité de 0,05 à 1 % en poids en fonction du poids total de ladite composition ;
ii) l'acide monocarboxylique est présent en une quantité de 0,25 à 1,25 % en poids en fonction du poids total de ladite composition ; ou
iii) à la fois i) et ii).

11. Composition selon l'une quelconque des revendications précédentes, dans laquelle ledit polymère et ledit polymère carboxylé sont dans un rapport pondéral de 1:1 à 1:3 (polymère:polymère carboxylé).

12. Conducteur formé à partir de la composition selon l'une quelconque des revendications précédentes.

13. Article comprenant :
i) un substrat ; et
ii) un conducteur disposé sur et en contact électrique avec ledit i) substrat pour le transport de courant, ledit ii) conducteur étant formé à partir ;
d'une poudre métallique,
d'une poudre à braser qui a une température de fusion inférieure à une température de fusion de ladite poudre métallique,
d'un polymère qui comprend une résine époxy,
d'un polymère carboxylé différent dudit polymère destiné à fluidifier ladite poudre métallique et à réticuler ledit polymère,
d'un acide dicarboxylique destiné à fluidifier ladite poudre métallique, et
d'un acide monocarboxylique destiné à fluidifier ladite poudre métallique ; et
d'un promoteur d'adhésion ou d'un agent anti-mousse,
dans lequel le rapport des groupes acides sur les groupes époxy est d'au moins 3:1.

14. Article selon la revendication 13, dans lequel ledit substrat est **caractérisé par** au moins une des caractéristiques suivantes :
i) est conducteur ;
ii) comprend de l'aluminium, de l'argent ou une combinaison de ceux-ci ;
iii) est diélectrique ;
iv) comprend du silicium ;
v) comprend un métal apte au brasage ; ou
v) comprend un métal non apte au brasage.

15. Article selon la revendication 13 ou 14, défini, en outre, en tant que cellule photovoltaïque (PV) ou carte de circuit.
